(19) Europäisches Patentamt / European Patent Office / Office européen des brevets

(11) EP 3 220 434 A1

(12) EUROPEAN PATENT APPLICATION
published in accordance with Art. 153(4) EPC

(43) Date of publication:
**20.09.2017 Bulletin 2017/38**

(21) Application number: **15859277.4**

(22) Date of filing: **05.11.2015**

(51) Int Cl.:
***H01L 51/30*** (2006.01) ***C08G 61/12*** (2006.01)
***C08L 65/00*** (2006.01) ***C08L 101/00*** (2006.01)
***H01L 21/28*** (2006.01) ***H01L 21/368*** (2006.01)
***H01L 29/786*** (2006.01) ***H01L 51/05*** (2006.01)

(86) International application number:
**PCT/JP2015/081177**

(87) International publication number:
**WO 2016/076196 (19.05.2016 Gazette 2016/20)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**MA MD**

(30) Priority: **12.11.2014 JP 2014229756**

(71) Applicant: **Fujifilm Corporation**
**Minato-ku**
**Tokyo 106-8620 (JP)**

(72) Inventor: **KITAMURA Tetsu**
**Ashigarakami-gun**
**Kanagawa 258-8577 (JP)**

(74) Representative: **Hoffmann Eitle**
**Patent- und Rechtsanwälte PartmbB**
**Arabellastraße 30**
**81925 München (DE)**

# (54) ORGANIC SEMICONDUCTOR ELEMENT AND COMPOUND

(57) An object of the invention is to provide an organic semiconductor element in which mobility is high, heat resistance is excellent, and variation of mobility is suppressed, and a manufacturing method thereof, to provide a novel compound that is suitable as an organic semiconductor, and to provide an organic semiconductor film in which mobility is high, heat resistance is excellent, and variation of mobility is suppressed and a composition for forming an organic semiconductor film that can suitably form the organic semiconductor film.

The organic semiconductor element according to the invention has an organic semiconductor layer containing a compound having a constitutional repeating unit represented by Formula 1 or 2 below.

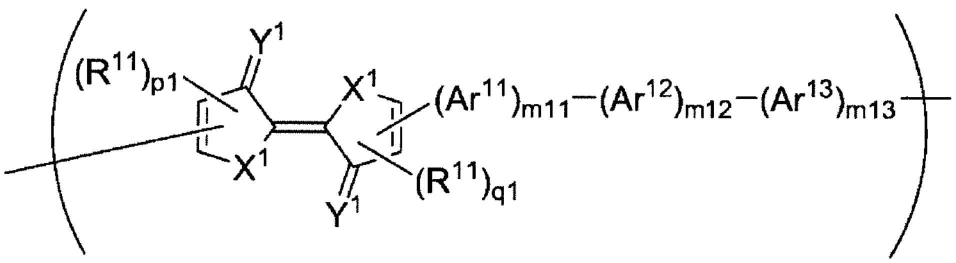

(1)

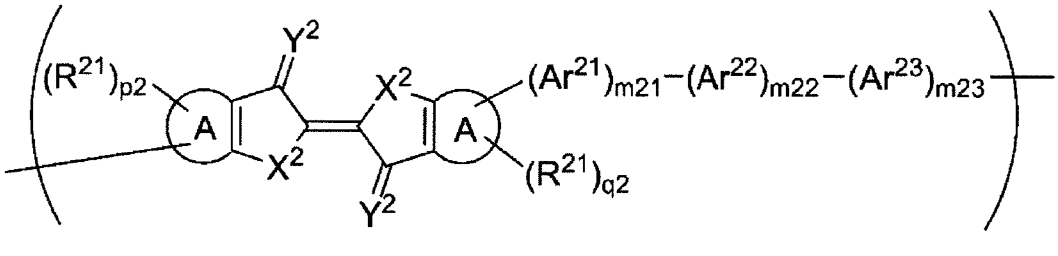

(2)

EP 3 220 434 A1

## Description

The invention relates to an organic semiconductor element, a manufacturing method thereof, a compound, a composition for forming an organic semiconductor film, and an organic semiconductor film.

An organic transistor having an organic semiconductor film (organic semiconductor layer) is used in a field effect transistor (FET) used in a liquid crystal display or an organic EL display, RFID (RF tag), and the like, because lightening of weight, cost reduction and flexibilization can be achieved.

As the organic semiconductor in the related art, those disclosed in JP2008-98454A are known.

An object to be achieved by the invention is to provide an organic semiconductor element in which mobility is high, heat resistance is excellent, and variation of mobility is suppressed, and a manufacturing method thereof.

Another object to be achieved by the invention is to provide a novel compound which is suitable as an organic semiconductor.

Still another object to be achieved by the invention is to provide an organic semiconductor film in which mobility is high, heat resistance is excellent, and variation of mobility is suppressed and a composition for forming an organic semiconductor film that can suitably form the organic semiconductor film.

The object of the invention is solved by the means described in <1>, <6>, <12>, <20>, or <21> below. <2> to <5>, <7> to <11>, <13> to <19>, and <22> to <26> which are preferable embodiments are also described below.

<1> An organic semiconductor element, comprising:

an organic semiconductor layer containing a compound having a constitutional repeating unit represented by Formula 1 or 2 below,

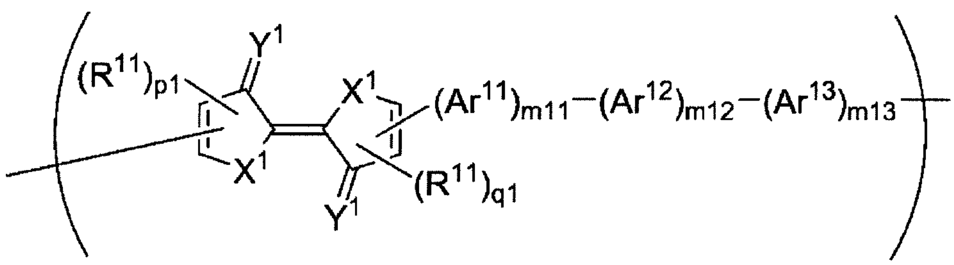

(1)

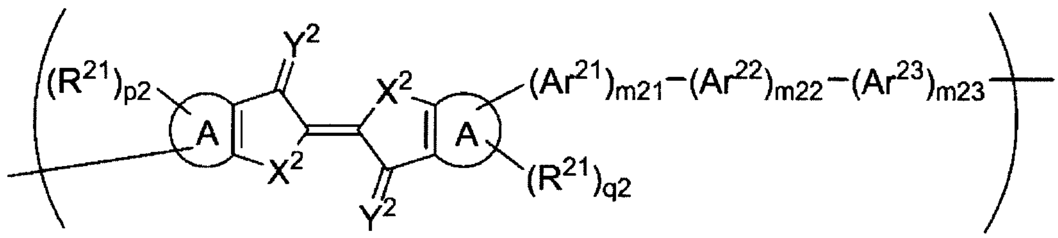

(2)

in Formulae 1 and 2, $X^1$ and $X^2$ each independently represent $CR^1_2$, O, S, Se, $NR^1$, or $SiR^1_2$, $R^1$'s each independently represent an alkyl group, an alkenyl group, an alkynyl group, an aromatic hydrocarbon group, or an aromatic heterocyclic group, $R^{11}$ and $R^{21}$ each independently represent a monovalent substituent, $Y^1$ and $Y^2$ each independently represent O, S, N-CN, or $CQ_2$, Q's each independently represent an alkyl group, CN, $C(=O)OR^2$, or $SO_2R^2$, $R^2$ represents a monovalent substituent, rings A each independently represent an aromatic hydrocarbon ring or an aromatic hetero ring, $Ar^{11}$, $Ar^{12}$, $Ar^{13}$, $Ar^{21}$, $Ar^{22}$, and $Ar^{23}$ each independently represent an aromatic hydrocarbon group, an aromatic heterocyclic group, a vinylene group, or an ethynylene group, m11 and m21 each represent an integer of 0 to 2, m12 and m22 each represent an integer of 0 to 4, m13 and m23 each represent an integer of 0 to 2, p1 and q1 each represent 0 or 1, p2 and q2 each represent an integer of 0 to 3.

<2> The organic semiconductor element according to <1>, in which the constitutional repeating unit represented by Formula 1 or 2 is represented by Formula 2, and in which the rings A are each independently selected from the group consisting of a benzene ring, a pyridine ring, a pyrimidine ring, a pyrazine ring, a furan ring, a thiophene ring, a selenophene ring, and a pyrrole ring.

<3> The organic semiconductor element according to <1> or <2>, in which $X^1$ and $X^2$ each independently represent O, S, or $NR^1$.

<4> The organic semiconductor element according to any one of <1> to <3>, in which the constitutional repeating

unit represented by Formula 1 or 2 is a constitutional repeating unit represented by Formula 3 below,

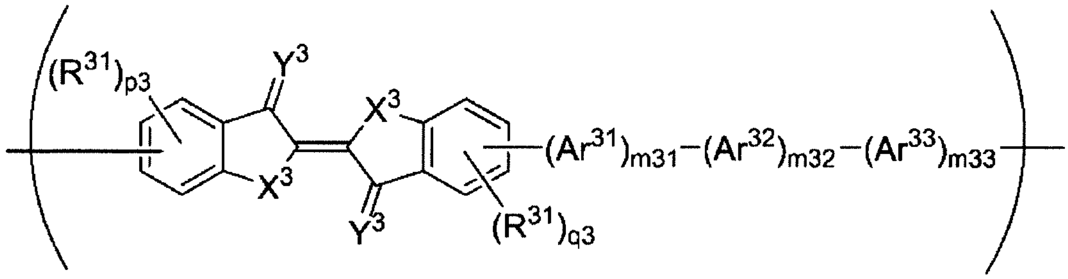

(3)

in Formula 3, $X^3$'s each independently represent $CR^1_2$, O, S, Se, $NR^1$, or $SiR^1_2$, $R^1$'s each independently represent an alkyl group, an alkenyl group, an alkynyl group, an aromatic hydrocarbon group, or an aromatic heterocyclic group, $R^{31}$'s each independently represent a monovalent substituent, $Y^3$'s each independently represent O, S, N-CN, or $CQ_2$, Q's each independently represent an alkyl group, CN, $C(=O)OR^2$, or $SO_2R^2$, $R^2$ represents a monovalent substituent, $Ar^{31}$, $Ar^{32}$, and $Ar^{33}$ each independently represent an aromatic hydrocarbon group, an aromatic heterocyclic group, a vinylene group, or an ethynylene group, m31 represents an integer of 0 to 2, m32 represents an integer of 0 to 4, m33 represents an integer of 0 to 2, and p3 and q3 each represent an integer of 0 to 3.

<5> The organic semiconductor element according to <4>, in which the constitutional repeating unit represented by Formula 3 is constitutional repeating unit represented by Formula 4 below,

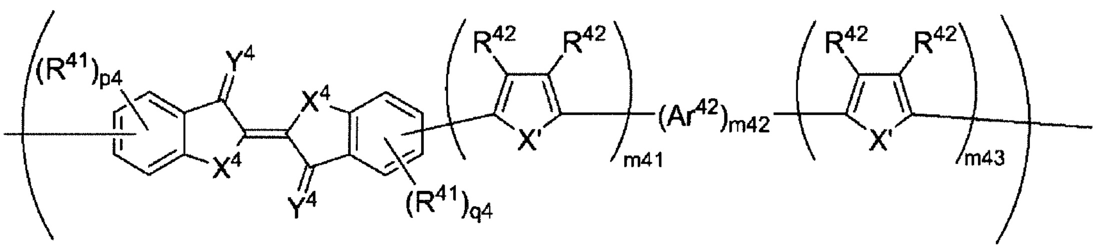

(4)

in Formula 4, $X^4$'s each independently represent $CR^1_2$, O, S, Se, $NR^1$, or $SiR^1_2$, $R^1$'s each independently represent an alkyl group, an alkenyl group, an alkynyl group, an aromatic hydrocarbon group, or an aromatic heterocyclic group, $R^{41}$'s each independently represent a monovalent substituent, $Y^4$'s each independently represent O, S, N-CN, or $CQ_2$, Q's each independently represent an alkyl group, CN, $C(=O)OR^2$, or $SO_2R^2$, $R^2$ represents a monovalent substituent, $Ar^{42}$'s each independently represent an aromatic hydrocarbon group, an aromatic heterocyclic group, a vinylene group, or an ethynylene group, m41 represents an integer of 0 to 2, m42 represents an integer of 0 to 4, m43 represents an integer of 0 to 2, p4 and q4 each represent an integer of 0 to 3, X''s each independently represent O or S, and $R^{42}$'s each independently represent a hydrogen atom or a monovalent substituent.

<6> A compound comprising: a constitutional repeating unit represented by Formula 1 or 2 above.

<7> The compound according to <6>, in which a constitutional repeating unit represented by Formula 1 or 2 above is represented by Formula 2, and in which the rings A are each independently selected from the group consisting of a benzene ring, a pyridine ring, a pyrimidine ring, a pyrazine ring, a furan ring, a thiophene ring, a selenophene ring, and a pyrrole ring.

<8> The compound according to <6> or <7>, in which $X^1$ and $X^2$ each independently represent O, S, or $NR^1$.

<9> The compound according to any one of <6> to <8>, in which the constitutional repeating unit represented by Formula 1 or 2 above is a constitutional repeating unit represented by Formula 3 above.

<10> The compound according to <9>, in which the constitutional repeating unit represented by Formula 3 above is a constitutional repeating unit represented by Formula 4 above.

<11> The compound according to any one of <6> to <10>, which is an organic semiconductor.

<12> A composition for forming an organic semiconductor film, comprising: a compound having a constitutional repeating unit represented by Formula 1 or 2 above; and a solvent.

<13> The composition for forming an organic semiconductor film according to <12>, in which a constitutional repeating unit represented by Formula 1 or 2 above is represented by Formula 2, and in which the rings A are each independently selected from the group consisting of a benzene ring, a pyridine ring, a pyrimidine ring, a pyrazine ring, a furan ring, a thiophene ring, a selenophene ring, and a pyrrole ring.

<14> The composition for forming an organic semiconductor film according to <12> or <13>, in which $X^1$ and $X^2$ each independently represent O, S, or $NR^1$.

<15> The composition for forming an organic semiconductor film according to any one of <12> to <14>, in which a constitutional repeating unit represented by Formula 1 or 2 above is a constitutional repeating unit represented by Formula 3 above.

<16> The composition for forming an organic semiconductor film according to <15>, in which a constitutional repeating unit represented by Formula 3 above is a constitutional repeating unit represented by Formula 4 above.

<17> The composition for forming an organic semiconductor film according to any one of <12> to <16>, in which a concentration of the compound having a constitutional repeating unit represented by Formula 1 or 2 above is 0.1 to 10 mass% with respect to the entire composition.

<18> The composition for forming an organic semiconductor film according to any one of <12> to <17>, in which a boiling point of the solvent is 100°C or higher.

<19> The composition for forming an organic semiconductor film according to any one of <12> to <18>, further comprising: a binder polymer.

<20> A method of manufacturing an organic semiconductor element, comprising: a coating step of coating a substrate with the composition for forming an organic semiconductor film according to any one of <12> to <19>.

<21> An organic semiconductor film comprising: a compound having a constitutional repeating unit represented by Formula 1 or 2 above.

<22> The organic semiconductor film according to <21>, in which a constitutional repeating unit represented by Formula 1 or 2 above is represented by Formula 2, and in which the rings A are each independently selected from the group consisting of a benzene ring, a pyridine ring, a pyrimidine ring, a pyrazine ring, a furan ring, a thiophene ring, a selenophene ring, and a pyrrole ring.

<23> The organic semiconductor film according to <21> or <22>, in which $X^1$ and $X^2$ each independently represent O, S, or $NR^1$.

<24> The organic semiconductor film according to any one of <21> to <23>, in which a constitutional repeating unit represented by Formula 1 or 2 above is a constitutional repeating unit represented by Formula 3 above.

<25> The organic semiconductor film according to <24>, in which the constitutional repeating unit represented by Formula 3 above is a constitutional repeating unit represented by Formula 4 above.

<26> The organic semiconductor film according to any one of <21> to <25>, which is formed by a solution coating method.

According to the invention, it is possible to provide an organic semiconductor element in which mobility is high, heat resistance is excellent, and variation of mobility is suppressed, and a manufacturing method thereof.

According to the invention, it is possible to provide a novel compound that is suitable as an organic semiconductor.

According to the invention, it is possible to provide an organic semiconductor film in which mobility is high, heat resistance is excellent, and variation of mobility is suppressed and to provide a composition for forming an organic semiconductor film that can suitably form the organic semiconductor film.

BRIEF DESCRIPTION OF THE DRAWINGS

Fig. 1 is a schematic cross-sectional view of an aspect of an organic semiconductor element of the present invention.

Fig. 2 is a schematic cross-sectional view of another aspect of the organic semiconductor element of the present invention.

Hereinafter, the contents of the present invention will be specifically described. The constituents in the following description will be explained based on typical embodiments of the present invention, but the present invention is not limited to the embodiments. In the specification of the present application, "to" is used to mean that the numerical values listed before and after "to" are a lower limit and an upper limit respectively. Furthermore, in the present invention, an organic EL element refers to an organic electroluminescence element.

In the present specification, in a case where there is no description regarding whether a group (atomic group) is substituted or unsubstituted, the group includes both of a group having a substituent and a group not having a substituent. For example, an "alkyl group" includes not only an alkyl group not having a substituent (unsubstituted alkyl group) but also an alkyl group having a substituent (substituted alkyl group).

In the present specification, in some cases, a chemical structural formula is described as a simplified structural formula in which a hydrogen atom is omitted.

In the present invention, "mobility" refers to "carrier mobility" and means either of both of electron mobility and hole mobility.

In the present invention, "mass%" and "weight%" have the same definition, and "part by mass" and "part by weight" have the same definition.
In the present invention, a combination of preferred aspects is more preferable.

(Organic semiconductor element and compound)

The organic semiconductor element according to the invention has an organic semiconductor layer containing a compound (hereinafter, referred to as a "specific compound") that has a constitutional repeating unit represented by Formula 1 or 2 above.
The compound having the constitutional repeating unit represented by Formula 1 or 2 above is preferably an organic semiconductor compound.
The inventors have diligently conducted research to find that, if the specific compound was contained, the obtained organic semiconductor element or the organic semiconductor film have high mobility, excellent heat resistance, and suppressed variation of mobility, such that the invention has been completed.
A mechanism of exhibiting detailed effects is not clear.

<Specific compound>

According to the invention, the specific compound has a constitutional repeating unit represented by Formula 1 or 2 below.

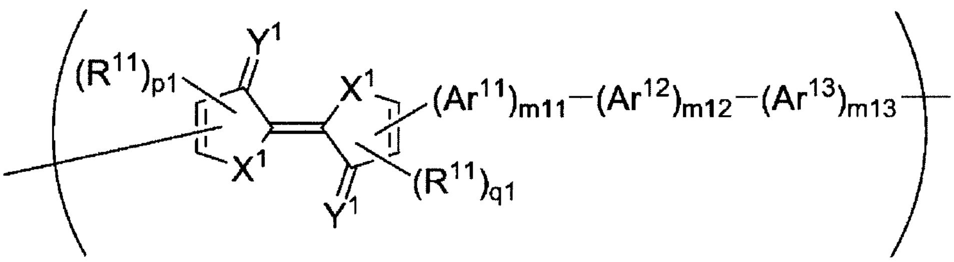

(1)

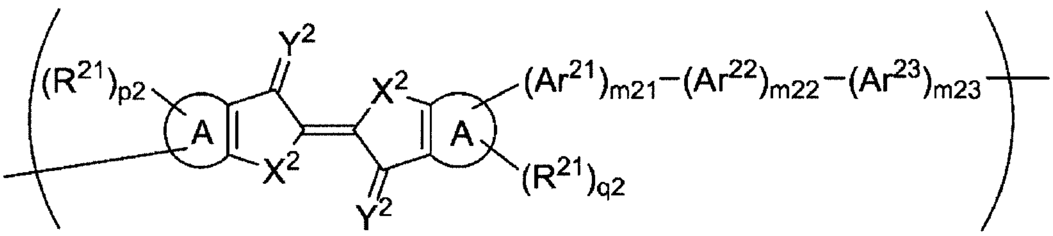

(2)

In Formulae 1 and 2, $X^1$ and $X^2$ each independently represent $CR^1_2$, O, S, Se, $NR^1$, or $SiR^1_2$, $R^1$'s each independently represent an alkyl group, an alkenyl group, an alkynyl group, an aromatic hydrocarbon group, or an aromatic heterocyclic group, $R^{11}$ and $R^{21}$ each independently represent a monovalent substituent, $Y^1$ and $Y^2$ each independently represent O, S, N-CN, or $CQ_2$, Q's each independently represent an alkyl group, CN, $C(=O)OR^2$, or $SO_2R^2$, $R^2$ represents a monovalent substituent, rings A each independently represent an aromatic hydrocarbon ring or an aromatic hetero ring, $Ar^{11}$, $Ar^{12}$, $Ar^{13}$, $Ar^{21}$, $Ar^{22}$, and $Ar^{23}$ each independently represent an aromatic hydrocarbon group, an aromatic heterocyclic group, a vinylene group, or an ethynylene group, m11 and m21 each represent an integer of 0 to 2, m12 and m22 each represent an integer of 0 to 4, m13 and m23 each represent an integer of 0 to 2, p1 and q1 each represent 0 or 1, and p2 and q2 each represent an integer of 0 to 3.
The specific compound according to the invention is preferably an organic semiconductor compound.
The specific compound according to the invention is a novel compound.
The specific compound according to the invention can be suitably used in an organic semiconductor element, an organic semiconductor film, and a composition for forming an organic semiconductor film.
In Formulae 1 and 2, $X^1$ and $X^2$ each independently represent $CR^1_2$, O, S, Se, $NR^1$, or $SiR^1_2$, $R^1$'s each independently represent an alkyl group, an alkenyl group, an alkynyl group, an aromatic hydrocarbon group, or an aromatic heterocyclic group. $X^1$ and $X^2$ each are preferably O, S, or $NR^1$, more preferably S or $NR^1$, and particularly preferably $NR^1$.
$R^1$ above represents an alkyl group, an alkenyl group, an alkynyl group, an aromatic hydrocarbon group, or an

aromatic heterocyclic group. When $X^1$ and $X^2$ represent $CR^1_2$ and $SiR^1_2$, plural $R^1$'s may be identical to or different from each other.

The alkyl group as $R^1$ may have any one of a linear shape, a branched shape, and a cyclic shape. The number of carbons of the alkyl group is preferably 4 to 50, more preferably 8 to 40, and even more preferably 12 to 30.

The alkenyl group as $R^1$ may have any one of a linear shape, a branched shape, and a cyclic shape. The number of carbon atoms of the alkenyl group is preferably 4 to 50, more preferably 8 to 40, and even more preferably 12 to 30.

The alkynyl group as $R^1$ may be any one of a linear shape, a branched shape, and a cyclic shape. The number of carbon atoms of the alkynyl group is preferably 4 to 50, more preferably 8 to 40, and even more preferably 12 to 30.

The aromatic hydrocarbon group as $R^1$ is preferably an aromatic hydrocarbon group having 6 to 20 carbon atoms, more preferably an aromatic hydrocarbon group having 6 to 10 carbon atoms, and particularly preferably a phenyl group or a naphthyl group.

The heteroatom included in the aromatic heterocyclic group as $R^1$ is not particularly limited and preferably has a heteroatom selected from the group consisting of an oxygen atom, a nitrogen atom, and a sulfur atom. Specifically, a group obtained by removing one hydrogen atom from a thiophene ring, a furan ring, a pyran ring, a pyrrole ring, a pyridine ring, a pyrazine ring, a pyrimidine ring, a pyridazine ring, an imidazole ring, and a thienothiophene ring is exemplified, but the invention is not limited thereto.

Among these, as $R^1$, an alkyl group (having 12 to 30 carbon atoms) is particularly preferable.

The alkyl group, the alkenyl group, the alkynyl group, the aromatic hydrocarbon group, and the aromatic heterocyclic group may further have a substituent. Examples of the substituent include a silyl group (including an oligosilyl group), a halogen atom, an alkyl group, an aromatic hydrocarbon group, and an aromatic heterocyclic group.

In Formulae 1 and 2, $R^{11}$ and $R^{21}$ each independently represent a monovalent substituent. Examples of the monovalent substituent represented by $R^{11}$ and $R^{12}$ include a halogen atom, an alkyl group (including a cycloalkyl group, a bicycloalkyl group, and a tricycloalkyl group), an alkenyl group, an alkynyl group, an aryl group (an aromatic hydrocarbon group), a heterocyclic group (also referred to as a heterocyclic group, and including an aromatic heterocyclic group, and an aliphatic heterocyclic group), a cyano group, a hydroxy group, a nitro group, a carboxy group, an alkoxy group, an aryloxy group, a silyloxy group, a heterocyclic oxy group, an acyloxy group, a carbamoyloxy group, an alkoxycarbonyloxy group, an aryloxycarbonyloxy group, an amino group (including an anilino group), an ammonio group, an acylamino group, an aminocarbonylamino group, an alkoxycarbonylamino group, an aryloxycarbonylamino group, a sulfamoylamino group, alkyl and arylsulfonylamino groups, a mercapto group, an alkylthio group, an arylthio group, a heterocyclic thio group, a sulfamoyl group, a sulfo group, alkyl and arylsulfinyl groups, alkyl and arylsulfonyl groups, an acyl group, an aryloxycarbonyl group, an alkoxycarbonyl group, a carbamoyl group, aryl and heterocyclic azo groups, an imide group, a phosphino group, a phosphinyl group, a phosphinyloxy group, a phosphinylamino group, a phosphono group, a silyl group (mono-, di-, and trialkylsilyl group, and including an oligosilyl group), a hydrazino group, an ureido group, a boronic acid group ($-B(OH)_2$), a phosphato group ($-OPO(OH)_2$), a sulfato group ($-OSO_3H$), and other well-known substituents. $R^{11}$ and $R^{21}$ may be further substituted with the substituent. Examples of the substituent include groups exemplified as R.

Among these, $R^{11}$ and $R^{21}$ is preferably a halogen atom, an alkyl group, an alkoxy group, an alkynyl group, an acyl group, an acyloxy group, an aryl group, and a heterocyclic group, more preferably a halogen atom, an alkyl group, an aryl group (an aromatic hydrocarbon group), or an aromatic heterocyclic group, and even more preferably an alkyl group or an aromatic heterocyclic group.

Examples of the halogen atom include a fluorine atom, a chlorine atom, a bromine atom, and an iodine atom, and a fluorine atom is preferable.

The alkyl group is preferably an alkyl group having 2 to 40 carbon atoms, more preferably an alkyl group having 3 to 24 carbon atoms, and even more preferably an alkyl group having 4 to 16 carbon atoms. The alkyl group may have any one of a linear shape, a branched shape, and a cyclic shape, or may have a structure obtained by combining these. However, a linear or branched alkyl group is preferable, and a linear alkyl group is more preferable.

The alkoxy group is preferably an alkoxy group having 2 to 18 carbon atoms, more preferably an alkoxy group having 3 to 15 carbon atoms, and even more preferably an alkoxy group having 4 to 12 carbon atoms. The portion of the alkyl group of the alkoxy group may be any one of a linear shape, a branched shape, and a cyclic shape, or may have a structure obtained by combining these. However, a linear or branched alkyl group is preferable.

The alkynyl group is preferably an alkynyl group having 2 to 18 carbon atoms, more preferably an alkynyl group having 3 to 15 carbon atoms, and even more preferably an alkynyl group having 4 to 12 carbon atoms.

The acyl group (R-C(=O)-) is preferably an acyl group having 2 to 18 carbon atoms, more preferably an acyl group having 3 to 15 carbon atoms, and even more preferably an acyl group having 4 to 12 carbon atoms.

The acyloxy (R-(=O)-O-) group is preferably an acyloxy group having 2 to 18 carbon atoms, more preferably an acyloxy group having 3 to 15 carbon atoms, and even more preferably an acyloxy group having 4 to 12 carbon atoms.

Examples of the aryl group (aromatic hydrocarbon group) include groups obtained by removing one hydrogen from benzene, naphthalene, anthracene, and the like.

Examples of the aromatic heterocyclic group include groups obtained by removing one hydrogen atom from a thiophene ring, a furan ring, a pyran ring, a pyrrole ring, a pyridine ring, a pyrazine ring, a pyrimidine ring, a pyridazine ring, a selenophene ring, and an imidazole ring. Groups obtained by removing one hydrogen atom from a thiophene ring, a selenophene ring, or a pyrrole ring are preferable, groups obtained by removing one hydrogen atom from a thiophene ring or a furan ring are more preferable, and a group obtained by removing one hydrogen atom from a thiophene ring is even more preferable.

In Formulae 1 and 2, $Y^1$ and $Y^2$ each independently represent O, S, N-CN, or $CQ_2$, Q's each independently represent an alkyl group, CN, $C(=O)OR^2$, or $SO_2R^2$, and $R^2$ represents a monovalent substituent. If $Y^1$ and $Y^2$ represent $CQ_2$, Q is an alkyl group, $C(=O)OR^2$, or $SO_2R^2$, alkyl groups or $R^2$'s may be connected to each other to form a ring. The formed ring structure may be an aliphatic hydrocarbon ring, may be an aromatic hydrocarbon ring or may be an aromatic hetero ring, and is not particularly limited.

The alkyl group as Q is preferably having 1 to 40 carbon atoms, more preferably having 1 to 20 carbon atoms, and even more preferably having 1 to 12 carbon atoms. The alkyl group may have a substituent, examples of the substituent include a halogen atom (F, Cl, Br, and I are exemplified, and F, Cl, and Br are preferable), an aromatic hydrocarbon group and an aromatic heterocyclic group are exemplified, and a haloalkyl group substituted with a halogen atom is preferable.

In Formulae 1 and 2, $R^2$ represents a monovalent substituent, and a monovalent organic group is preferable. $R^2$ is more preferably an alkyl group or an aryl group and even more preferably an alkyl group. The alkyl group preferably has 1 to 40 carbon atoms, more preferably has 1 to 24, and even more preferably has 1 to 18 carbon atoms.

$Y^1$ and $Y^2$ are preferably O, S, and $CQ_2$, more preferably O and S, and even more preferably O.

In Formula 2, the rings A each independently represent a monocyclic or polycyclic aromatic hydrocarbon ring or a monocyclic or polycyclic aromatic hetero ring. The rings A each are preferably a monocyclic to tricyclic fused ring, more preferably a monocyclic or bicyclic fused ring, even more preferably a monocyclic aromatic hydrocarbon ring or a monocyclic aromatic hetero ring, and particularly preferably a 5-membered or 6-membered monocyclic aromatic hydrocarbon ring or a 5-membered or 6-membered aromatic hetero ring. In a case where the rings A each are polycyclic ring, the respective rings are preferably 5-membered or 6-membered rings. In a case where the rings A have polycyclic fused ring structures, the same aromatic hydrocarbon rings or the same aromatic hetero rings may be condensed, or different aromatic hydrocarbon rings or different aromatic hetero rings may be condensed. However, the same aromatic hydrocarbon rings or the same aromatic hetero rings are preferably condensed.

As the aromatic hydrocarbon ring, benzene rings are preferable.

The heteroatom of the aromatic hetero ring is not particularly limited, but the heteroatom is preferably S, O, N, and Se, more preferably S, O, N, even more preferably S, N, and particularly preferably S. Examples of the aromatic hetero ring include a thiophene ring, a furan ring, a pyran ring, a pyrrole ring, a pyridine ring, a pyrazine ring, a pyrimidine ring, a pyridazine ring, a selenophene ring, and an imidazole ring.

Among these, the rings A are each independently preferably selected from the group consisting of a benzene ring, a pyridine ring, a pyrimidine ring, a pyrazine ring, a furan ring, a thiophene ring, a selenophene ring, and a pyrrole ring, more preferably selected from the group consisting of a benzene ring, a thiophene ring, a selenophene ring, and a pyridine ring, even more preferably selected from the group consisting of a benzene ring, a thiophene ring, and a pyridine ring, particularly preferably a benzene ring or a thiophene ring, and most preferably a benzene ring.

The plural rings A may be identical to or different from each other, and are not particularly limited. However, in view of synthesis and mobility, it is preferable that the rings A are identical to each other.

$Ar^{11}$, $Ar^{12}$, $Ar^{13}$, $Ar^{21}$, $Ar^{22}$, and $Ar^{23}$ each independently represent an aromatic hydrocarbon group, an aromatic heterocyclic group, a vinylene group, or an ethynylene group.

$Ar^{11}$, $Ar^{13}$, $Ar^{21}$, and $Ar^{23}$ each are preferably an aromatic hydrocarbon group or an aromatic heterocyclic group, and preferably a monocyclic aromatic hydrocarbon group or a monocyclic aromatic heterocyclic group.

The aromatic hydrocarbon group is preferably an arylene group having 6 to 20 carbon atoms, more preferably a phenylene group or a naphthylene group, and even more preferably a phenylene group.

The heteroatom of the aromatic heterocyclic group is not particularly limited. However, S, O, N, and Se are exemplified. The aromatic heterocyclic group is preferably a group obtained by removing two hydrogen atoms from an aromatic hetero ring selected from the group consisting of a thiophene ring, a furan ring, a pyran ring, a pyrrole ring, a pyridine ring, a pyrazine ring, a pyrimidine ring, a pyridazine ring, a selenophene ring, an imidazole ring, and a thienothiophene ring, more preferably a group obtained by removing two hydrogen atoms from an aromatic hetero ring selected from the group consisting of a thiophene ring, a furan ring, a pyrrole ring, a pyridine ring, a selenophene ring, and a thienothiophene ring, and even more preferably a group obtained by removing two hydrogen atoms from a thiophene ring.

$Ar^{11}$, $Ar^{13}$, $Ar^{21}$, and $Ar^{23}$ each are most preferably a group obtained by removing two hydrogen atoms from a phenylene group or a thiophene ring.

The aromatic hydrocarbon group or the aromatic heterocyclic group may have a substituent. Examples of the preferable substituent include a halogen atom or an alkyl group. The alkyl group is preferably an alkyl group having 1

to 20 carbon atoms and more preferably an alkyl group having 8 to 20 carbon atoms. The alkyl group may have a substituent and examples of the substituent include a halogen atom.

In view of manufacturing suitability, it is preferable that $Ar^{11}$ and $Ar^{13}$ are identical to each other and $Ar^{21}$ and $Ar^{23}$ are identical to each other.

$Ar^{12}$ and $Ar^{22}$ each represent an aromatic hydrocarbon group, an aromatic heterocyclic group, a vinylene group, or an ethynylene group.

The aromatic hydrocarbon group is preferably an arylene group having 6 to 20 carbon atoms and preferably a group obtained by removing two hydrogen atoms from a phenylene group, a naphthylene group, or an anthracene ring.

The heteroatom of the aromatic hetero ring is not particularly limited, and examples thereof include S, O, N, Se, and Si. Examples of the aromatic heterocyclic group include a group obtained by removing two hydrogen atoms from a ring selected from the group consisting of a thiophene ring, a furan ring, a pyran ring, a pyrrole ring, a pyridine ring, a pyrazine ring, a pyrimidine ring, a pyridazine ring, a selenophene ring, an imidazole ring, and a thienothiophene ring. The aromatic heterocyclic group is preferably a group obtained by removing two hydrogen atoms from a ring selected from the group consisting of a thiophene ring, a furan ring, a pyrrole ring, a pyridine ring, a selenophene ring, and a thienothiophene ring, more preferably a group obtained by removing two hydrogen atoms from a ring selected from the group consisting of a thiophene ring and a thienothiophene ring, and even more preferably a group obtained by removing two hydrogen atoms from a thiophene ring.

The aromatic hydrocarbon group or the aromatic heterocyclic group each may have a substituent. Examples of the preferable substituent include an alkyl group, and the preferable substituent is preferably an alkyl group having 1 to 20 carbon atoms and more preferably an alkyl group having 8 to 20 carbon atoms.

$Ar^{12}$ and $Ar^{22}$ are preferably a polycyclic aromatic hydrocarbon group, a polycyclic aromatic heterocyclic group, a vinylene group, or an ethynylene group.

The polycyclic aromatic hydrocarbon group and the polycyclic aromatic heterocyclic group each preferably have a fused polycyclic ring structure of two to eight rings and more preferably have a fused polycyclic ring structure of two to five rings.

The polycyclic aromatic hydrocarbon group is preferably a group obtained by removing two hydrogen atoms from a naphthylene group and an anthracene ring or a group obtained by removing two hydrogen atoms from a pyrene ring.

The polycyclic aromatic heterocyclic group is preferably a group obtained by removing two hydrogen atoms from a thienothiophene ring and a structure represented by any one of Formulae AR-1 to AR-10 below.

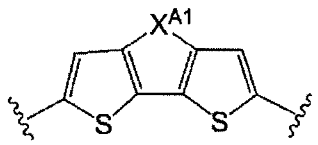

(AR-1)

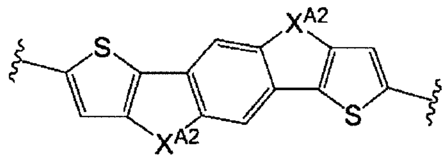

(AR-2)

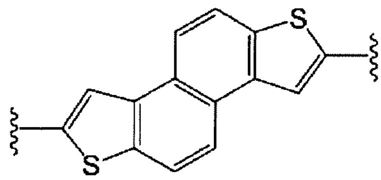

(AR-3)

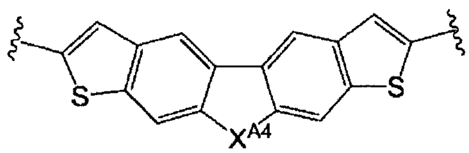

(AR-4)

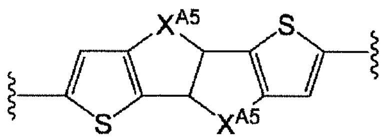

(AR-5)

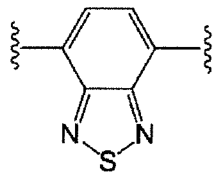

(AR-6)

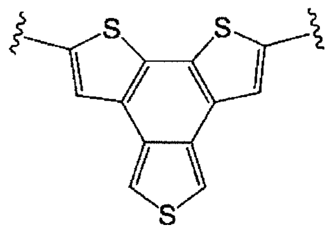 (AR-7) 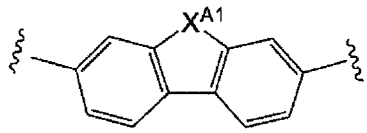 (AR-8)

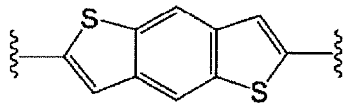 (AR-9) 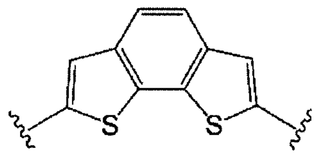 (AR-10)

In Formulae AR-1 to AR-10, $X^{A1}$, $X^{A2}$, $X^{A4}$, and $X^{A5}$ each independently represent any one of S, O, $CR^{AR}_2$, $NR^{AR}$, and $SiR^{AR}_2$, and $R^{AR}$'s each independently represent a monovalent organic group. $R^{AR}$ is preferably an alkyl group having 8 to 20 carbon atoms.

Among these, AR-1 to AR-6, AR-9, or AR-10 is preferable, any one of AR-1 to AR-5 is more preferable, and AR-1 or AR-5 is even more preferable.

The polycyclic aromatic hydrocarbon group or the polycyclic aromatic heterocyclic group may have a substituent. Examples of the preferable substituent include an alkyl group, an alkyl group having 1 to 30 carbon atoms is preferable, and an alkyl group having 8 to 20 carbon atoms is more preferable.

In Formulae 1 and 2, m11 and m21 each represent an integer of 0 to 2, m12 and m22 each represent an integer of 0 to 4, and m13 and m23 each represent an integer of 0 to 2. The sum of m11, m12, and m 13 is preferably 1 or greater, more preferably 2 or greater, and even more preferably 3 or greater. In view of the synthesis, the sum is preferably 7 or less, more preferably 6 or less, and even more preferably 5 or less.

In a case where $Ar^{12}$ or $Ar^{22}$ is a vinylene group or an ethynylene group, $Ar^{11}$, $Ar^{13}$, $Ar^{21}$, and $Ar^{23}$ each independently and preferably represent 1 or 2.

In a case where $Ar^{12}$ or $Ar^{22}$ is a polycyclic aromatic hydrocarbon group or a polycyclic aromatic heterocyclic group, m12 and m22 each are preferably 1 to 3, m11, m13, m21, and m23 each independently and preferably represent 0 or 1.

In Formulae 1 and 2, p1 and q1 represent 0 or 1, p2 and q2 each represent an integer of 0 to 3.

p1 and q1 are preferably 0.

p2 and q2 each are preferably an integer of 0 to 2, more preferably 0 or 1, and even more preferably 0.

The constitutional repeating unit represented by Formula 1 or 2 is preferably a repeating unit represented by Formula 2.

The constitutional repeating unit represented by Formula 1 or 2 preferably has at least one alkyl group preferably having 8 or more carbon atoms, more preferably having 10 or more carbon atoms, and even more preferably having 12 or more carbon atoms. If the constitutional repeating unit has an alkyl group having 8 or greater carbon atoms, solubility is excellent. The alkyl group may be $R^{11}$ or $R^{21}$, may be $R^1$, may be $R^2$, and $Ar^{11}$ to $Ar^{13}$ or $Ar^{21}$ to $Ar^{23}$ may be included as substituents and are not particularly limited.

The constitutional repeating unit represented by Formula 1 or 2 is preferably a constitutional repeating unit represented by Formula 3 below.

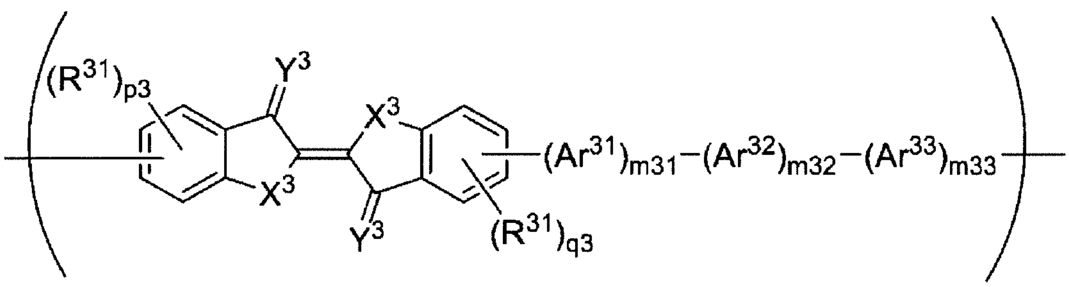 (3)

In Formula 3, $X^3$'s each independently represent $CR^1_2$, O, S, Se, $NR^1$, or $SiR^1_2$, $R^1$'s each independently represent an alkyl group, an alkenyl group, an alkynyl group, an aromatic hydrocarbon group, or an aromatic heterocyclic group, $R^{31}$'s each independently represent a monovalent substituent, $Y^3$'s each independently represent O, S, N-CN,

or $CQ_2$, Q's each independently represent an alkyl group, CN, C(=O)$OR^2$, or $SO_2R^2$, $R^2$ represents a monovalent substituent, $Ar^{21}$, $Ar^{32}$, and $Ar^{33}$ each independently represent an aromatic hydrocarbon group, an aromatic heterocyclic group, a vinylene group, or an ethynylene group, m31 represents an integer of 0 to 2, m32 represents an integer of 0 to 4, m33 represents an integer of 0 to 2, and p3 and q3 each represent an integer of 0 to 3.

In Formula 3, $X^3$, $Y^3$, $R^{31}$, $Ar^{31}$, $Ar^{32}$, $Ar^{33}$, m31, m32, m33, p3, and q3 have the same meaning respectively as $X^2$, $Y^2$, $Ar^2$, $Ar^{22}$, $Ar^{23}$, m21, m22, m23, p2, and q2 in Formula 2, and preferable ranges thereof are also the same.

According to the invention, the constitutional repeating unit represented by Formula 3 above is preferably a constitutional repeating unit represented by Formula 4 below.

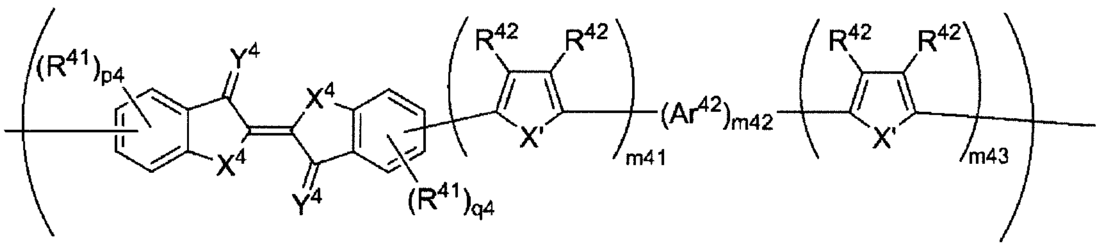
(4)

In Formula 4, $X^4$'s each independently represent $CR^1_2$, O, S, Se, $NR^1$, or $SiR^1_2$, $R^1$'s each independently represent an alkyl group, an alkenyl group, an alkynyl group, an aromatic hydrocarbon group, or an aromatic heterocyclic group, $R^{41}$'s each independently represent a monovalent substituent, $Y^4$'s each independently represent O, S, N-CN, or $CQ_2$, Q's each independently represent an alkyl group, CN, C(=O)$OR^2$, or $SO_2R^2$, $R^2$ represents a monovalent substituent, $Ar^{42}$'s each independently represent an aromatic hydrocarbon group, an aromatic heterocyclic group, a vinylene group, or an ethynylene group, m41 represents an integer of 0 to 2, m42 represents an integer of 0 to 4, m43 represents an integer of 0 to 2, p4 and q4 each represent an integer of 0 to 3, X"s each independently represent O or S, $R^{42}$ each independently represent a hydrogen atom or a monovalent substituent.

In Formula 4, $X^4$, $Y^4$, $R^{41}$, p4, and q4 have the same meaning respective as $X^2$, $Y^2$, $R^{21}$, p2, and q2 in Formula 2, and preferable ranges thereof are also the same.

In Formula 4, X"s each independently represent O or S. X' is preferably S.

In Formula 4, $R^{42}$'s each independently represent a hydrogen atom or a monovalent substituent. The monovalent substituent is preferably an alkyl group, preferably an alkyl group having 1 to 40 carbon atoms and more preferably an alkyl group having 8 to 20 carbon atoms. $R^{42}$ is preferably a hydrogen atom or an alkyl group.

In Formula 4, $Ar^{42}$ have the same meaning as $Ar^{22}$ in Formula 2, and preferable ranges thereof are also the same.

In Formula 4, m41, m42, and m43 have the same meaning as m21, m22, and m23 in Formula 2, and preferable ranges thereof are also the same.

In the specific compound, the content of the constitutional repeating unit represented by Formula 1 or 2 is preferably 60 to 100 mass%, more preferably 80 to 100 mass%, and even more preferably 90 to 100 mass% with respect to the total mass of the specific compound. It is particularly preferable that the constitutional repeating unit is substantially formed only with the constitutional repeating unit represented by Formula 1 or 2. The expression "the constitutional repeating unit is substantially formed only with the constitutional repeating unit represented by Formula 1 or 2" means that the content of the constitutional repeating unit represented by Formula 1 or 2 is 95 mass% or greater, preferably 97 mass% or greater, and more preferably 99 mass% or greater.

If the content of the constitutional repeating unit represented by Formula 1 or 2 is in the range above, an organic semiconductor having excellent mobility can be obtained.

The specific compound is a compound having two or more constitutional repeating units represented by Formula 1 or 2 and may be an oligomer in which the number "n" of constitutional repeating units is two to nine or may be a polymer in which the number "n" of constitutional repeating units is 10 or greater. Among these, a polymer in which the number "n" of constitutional repeating units is 10 or greater is preferable, in view of mobility and obtainable physical properties of the organic semiconductor film.

The weight-average molecular weight of the specific compound is not particularly limited. However, in view of film quality stability of a thin film and mobility, the weight-average molecular weight is preferably 1,000 or greater, more preferably 10,000 or greater, even more preferably 20,000 or greater, and particularly preferably 50,000 or greater. In view of solubility to the solvent, the weight-average molecular weight is preferably 2,000,000 or less, more preferably 1,000,000 or less, even more preferably 500,000 or less, particularly preferably 250,000 or less, and most preferably 100,000 or less.

If the weight-average molecular weight in the range above, solubility of the solvent and the film quality stability are compatible with each other.

According to the invention, a weight-average molecular weight and a number-average molecular weight are

measured by a gel permeation chromatography method (GPC method) and can be obtained in terms of standard polystyrene. Specifically, for example, HLC-8220GPC (manufactured by manufactured by Tosoh Corporation) is used as GPC, three of TSKgeL SuperHZM-H, TSKgeL SuperHZ4000, TSKgeL SuperHZ2000 (manufactured by Tosoh Corporation, 4.6 mmID×15 cm) are used as columns, and THF (tetrahydrofuran) is used as an eluent. As the condition, the sample concentration is set as 0.35 mass%, a flow rate is set as 0.35 ml/min, a sample injection volume is set as 10μl, a measurement temperature is set as 40°C, and an IR detector was used, so as to perform gel permeation chromatography. A calibration curve is manufactured from eight samples of "standard sample TSK standard, polystyrene": "F-40", "F-20", "F-4", "F-1", "A-5000", "A-2500", "A-1000", and "n-propylbenzene" manufactured by Tosoh Corporation.

In an organic semiconductor layer described below, and an organic semiconductor film or a composition for forming an organic semiconductor film described below, only one specific compound may be included, and two or more types of the specific compounds may be included. However, in view of alignment, only one type is preferable.

Hereinafter, A-1 to A-32 which are preferable specific examples of the preferable constitutional repeating unit represented by Formula 1 or 2. However, the invention is not limited to the examples below.

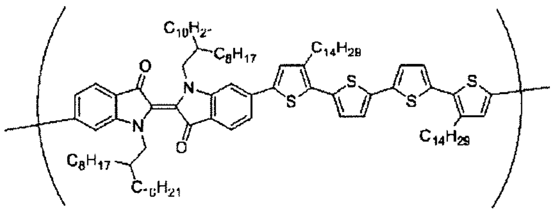

(A-1)

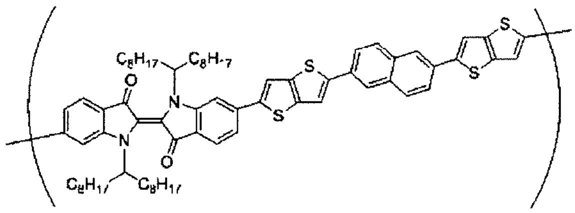

(A-2)

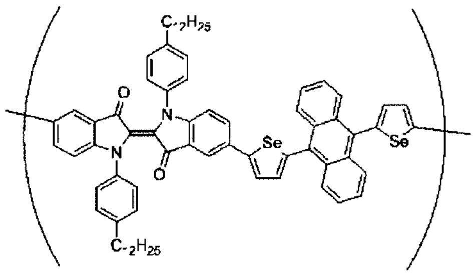

(A-3)

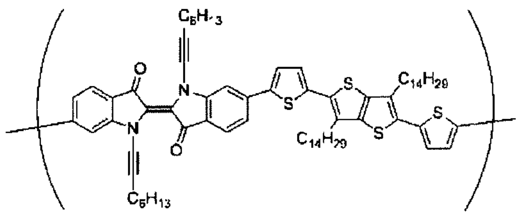

(A-4)

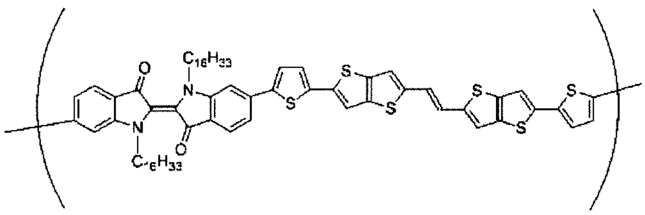

(A-5)

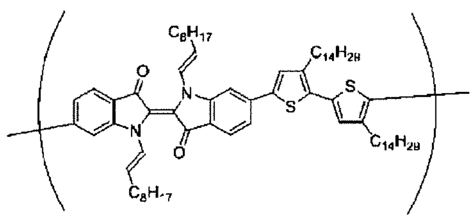

(A-6)

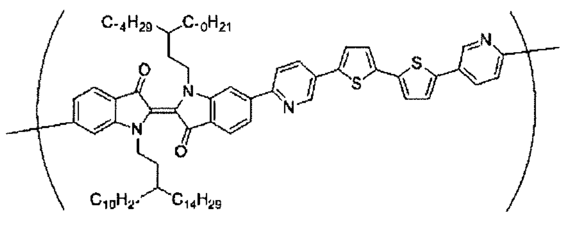

(A-7)

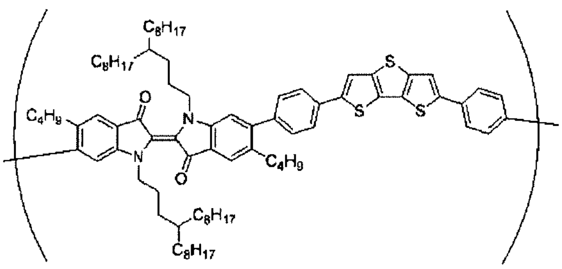

(A-8)

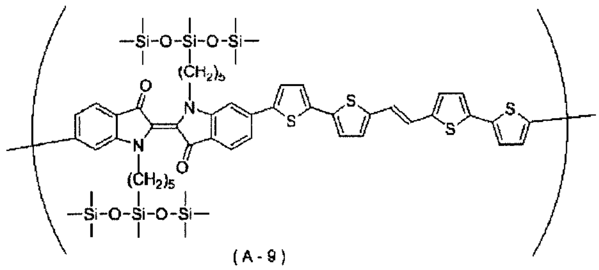

(A-9)

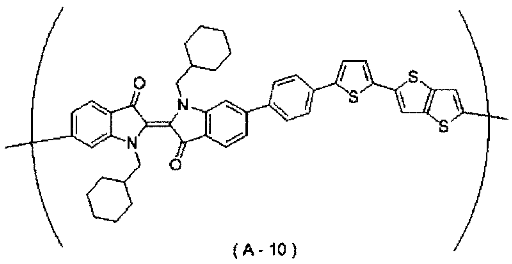

(A-10)

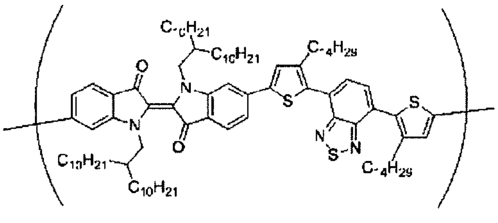

(A-11)

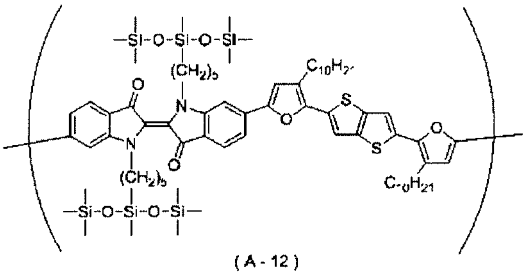

(A-12)

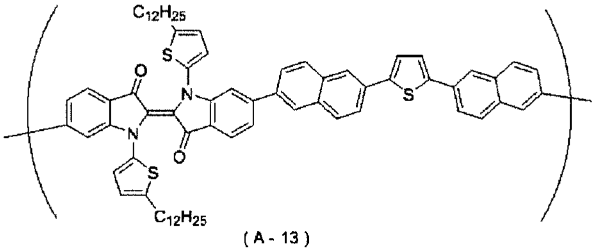

(A-13)

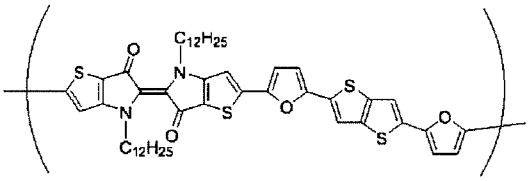

(A-14)

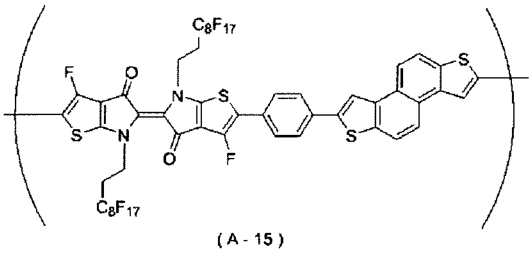

(A-15)

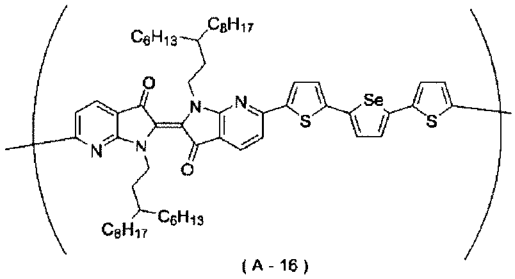

(A-16)

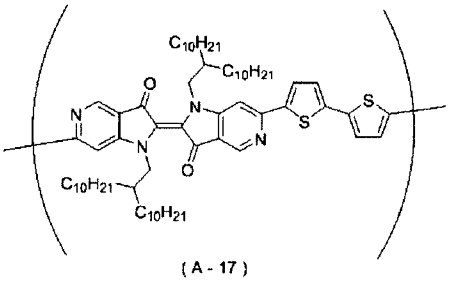

(A-17)

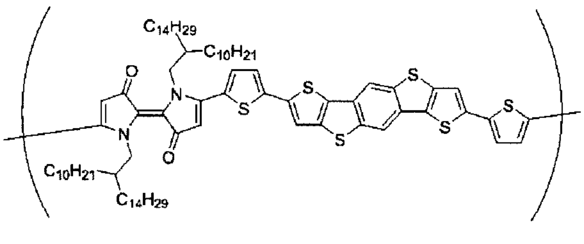

(A-18)

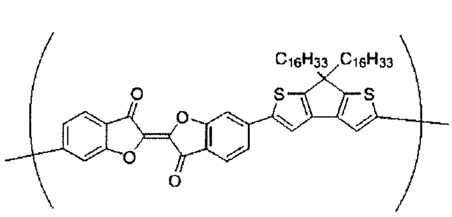

( A - 19 )

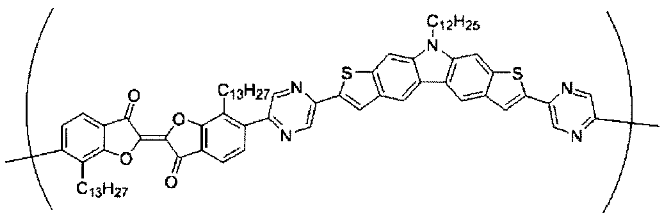

( A - 20 )

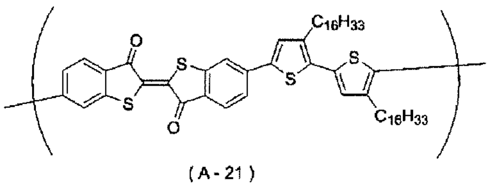

( A - 21 )

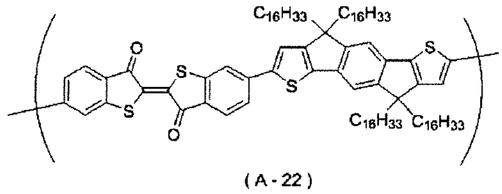

( A - 22 )

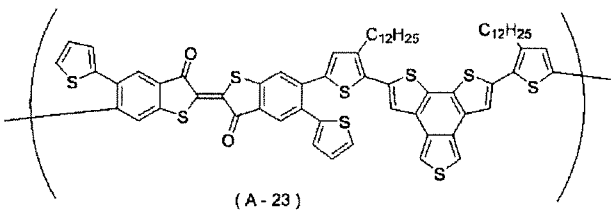

( A - 23 )

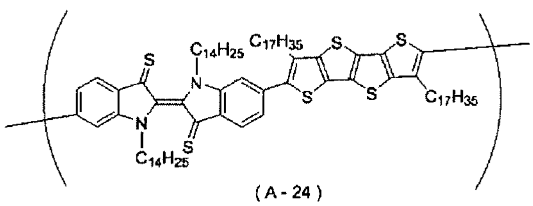

( A - 24 )

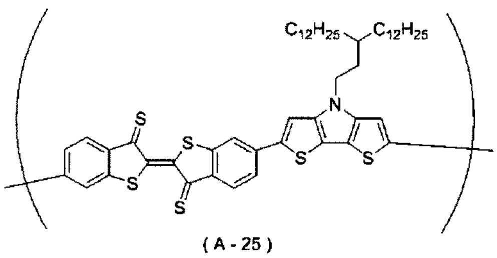

( A - 25 )

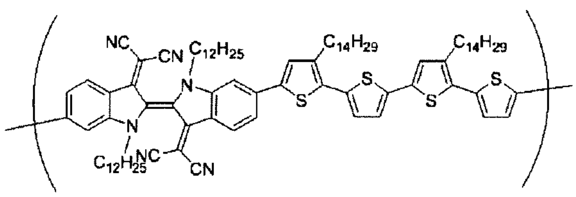

( A - 26 )

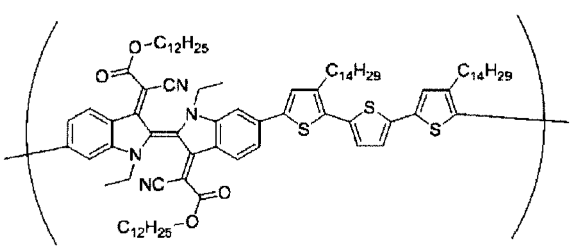

( A - 27 )

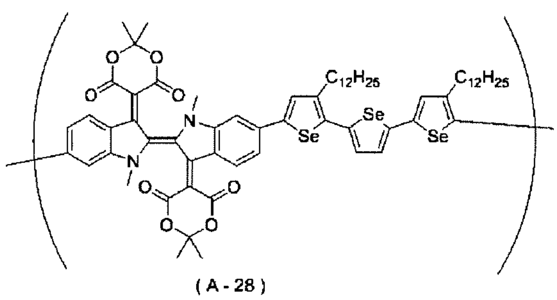

( A - 28 )

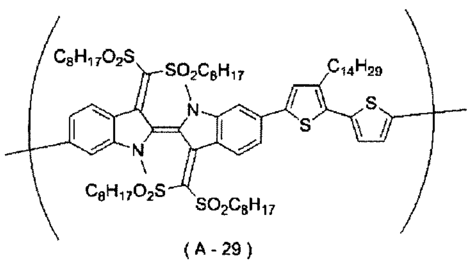

( A - 29 )

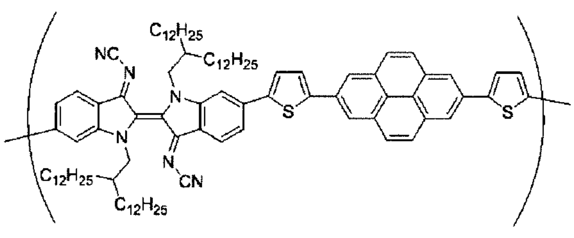

( A - 30 )

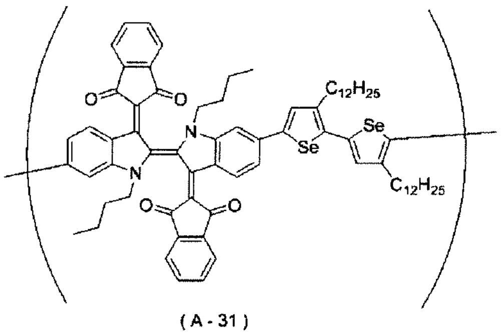

(A-31)

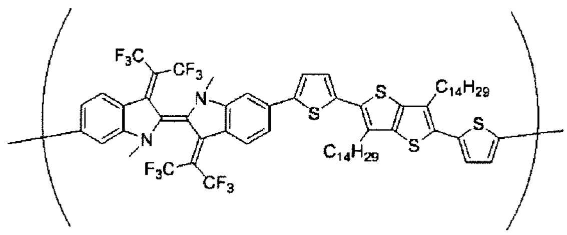

(A-32)

Among these, according to the invention, A-1, A-9, A-11, A-12, A-14, A-16, A-17, A-19, A-21, A-22, A-24, and A-25 are preferable, A-1, A-9, A-14, A-19, A-21, A-22, and A-24 are more preferable, and A-1, A-9, A-21, and A-22 are even more preferable.

A method of synthesizing the specific compound is not particularly limited, and the synthesis is performed by well-known methods. For example, J. Mater. Chem. C, 2014, 2, 4289, Liebigs Ann. Chem, 1980, 4, 564 and the like can be referred to.

<Binder polymer>

The organic semiconductor layer of the organic semiconductor element according to the invention preferably contains the binder polymer.

The organic semiconductor element according to the invention may be an organic semiconductor element having a layer including the organic semiconductor layer and the binder polymer.

The types of the binder polymer are not particularly limited, and well-known binder polymers can be used.

Examples of the binder polymer includes insulating polymers such as polystyrene, polycarbonate, polyarylate, polyester, polyamide, polyimide, polyurethane, polysiloxane, polysulfone, polymethyl methacrylate, polymethyl acrylate, cellulose, polyethylene, and polypropylene, and copolymers thereof, a semiconductor polymer such as polysilane, polycarbazole, polyarylamine, polyfluorene, polythiophene, polypyrrole, polyaniline, polyparaphenylenevinylene, polyacene, and polyheteroacene, and copolymers thereof, and rubber, and a thermoplastic elastomer.

Among these, as the binder polymer, a polymer compound (a polymer having a monomer unit having a benzene ring group) having a benzene ring is preferable. The content of the monomer unit having a benzene ring group is not particularly limited. However, the content is preferably 50 mol% or greater, more preferably 70 mol% or greater, and even more preferably 90 mol% or greater with respect to the entire monomer unit. The upper limit is not particularly limited, but examples of the upper limit include 100 mol%.

Examples of the binder polymer include polystyrene, poly($\alpha$-methylstyrene), polyvinyl cinnamate, poly(4-vinylphenyl), poly(4-methylstyrene), poly[bis(4-phenyl) (2,4,6-trimethylphenyl)amine], and poly[2,6-(4,4-bis(2-ethylhexyl)-4H cyclopenta[2,1-b;3,4-b']dithiophene)-alt-4,7-(2,1,3-benzothiadiazole)], and poly($\alpha$-methylstyrene) is particularly preferable.

A weight-average molecular weight of the binder polymer is not particularly limited, but is preferably 1,000 to 2,000,000, more preferably 3,000 to 1,000,000, and even more preferably 5,000 to 600,000.

In a case where a solvent described below is used, it is preferable that the binder polymer exhibits solubility higher than the solubility of the specific compound in a used solvent. If the above aspect is adopted, mobility and heat stability of the obtained organic semiconductor are further improved.

A content of the binder polymer in the organic semiconductor layer of the organic semiconductor element of the present invention is preferably 1 to 200 parts by mass, more preferably 10 to 150 parts by mass, and even more preferably 20 to 120 parts by mass with respect to 100 parts by mass of the content of the specific compound. If the content is within the above range, mobility and heat stability of the obtained organic semiconductor are further improved.

<Other components>

Other components may be included other than the specific compound and the binder polymer may be included in the organic semiconductor layer according to the organic semiconductor element of the invention.

As other components, known additives and the like can be used.

In the organic semiconductor layer of the present invention, a content of the components other than the specific compound and the binder polymer is preferably 10 mass% or less, more preferably 5 mass% or less, even more preferably 1 mass% or less, and particularly preferably equal to or less than 0.1 mass%. If the content of other components is

within the above range, film formability is improved, and mobility and heat stability of the obtained organic semiconductor are further improved.

The method of forming the organic semiconductor layer according to the organic semiconductor element of the invention is not particularly limited. However, a desired organic semiconductor layer can be formed by applying the composition for forming the organic semiconductor film according to the invention described below to a source electrode, a drain electrode, and a gate insulating film and performing a drying treatment, if necessary.

The organic semiconductor element of the present invention is preferably manufactured using the composition for forming an organic semiconductor film of the present invention described below.

A method of manufacturing an organic semiconductor film or an organic semiconductor element by using the composition for forming an organic semiconductor film of the present invention is not particularly limited, and known methods can be adopted. Examples thereof include a method of manufacturing an organic semiconductor film by applying the composition onto a predetermined base material and if necessary, performing a drying treatment.

The method of applying the composition onto a base material is not particularly limited, and known methods can be adopted. Examples thereof include an ink jet printing method, a flexographic printing method, a bar coating method, a spin coating method, a knife coating method, a doctor blade method, and the like. Among these, an ink jet printing method and a flexographic printing method are preferable.

Preferred examples of the flexographic printing method include an aspect in which a photosensitive resin plate is used as a flexographic printing plate. By printing the composition onto a substrate according to the aspect, a pattern can be easily formed.

Among the above methods, the method of manufacturing an organic semiconductor element of the present invention preferably includes a coating step of coating a substrate with the composition for forming an organic semiconductor film of the present invention. The composition for forming an organic semiconductor film of the present invention more preferably contains a solvent, and the method of manufacturing an organic semiconductor film of the present invention and the method of manufacturing an organic semiconductor element of the present invention more preferably includes a coating step of coating a substrate with the composition for forming an organic semiconductor film of the present invention and a removing step of removing the solvent from the composition with which the substrate is coated.

The composition for forming the organic semiconductor film according to the invention described below preferably includes a solvent and more preferably includes an organic solvent.

As the solvent, well-known solvents can be used.

Specifically, examples thereof include a hydrocarbon-based solvent such as hexane, octane, decane, toluene, xylene, mesitylene, ethylbenzene, decalin, and 1-methylnaphthalene, a ketone-based solvent such as acetone, methyl ethyl ketone, methyl isobutyl ketone, or cyclohexanone, a halogenated hydrocarbon-based solvent such as dichloromethane, chloroform, tetrachloromethane, dichloroethane, trichloroethane, tetrachloroethane, chlorobenzene, dichlorobenzene, and chlorotoluene, an ester-based solvent such as ethyl acetate, butyl acetate, and amyl acetate, an alcohol-based solvent such as methanol, propanol, butanol, pentanol, hexanol, cyclohexanol, methyl cellosolve, ethyl cellosolve, and ethylene glycol, an ether-based solvent such as dibutyl ether, tetrahydrofuran, dioxane, and anisole, an amide-based solvent such as N,N-dimethylformamide and N,N-dimethylacetamide, an imide-based solvent such as 1-methyl-2-pyrrolidone and 1-methyl-2-imidazolidinone, a sulfoxide-based solvent such as dimethylsulfoxide, and a nitrile-based solvent such as acetonitrile.

The solvent may be used singly or two or more types thereof may be used in combination.

Among these, a hydrocarbon-based solvent, a halogenated hydrocarbon-based solvent, an aromatic solvent, an aromatic heterocyclic solvent, and/or an ether-based solvent are preferable, and toluene, xylene, mesitylene, tetralin, dichlorobenzene and anisole are more preferable.

The boiling point of the solvent is preferably 100°C or higher, in view of film formability. The boiling point of the solvent is more preferably 100°C to 300°C, even more preferably 125°C to 250°C, and particularly preferably 150°C to 225°C.

It is preferable that a boiling point of the solvent of which the content is the greatest is 100°C or higher and, it is more preferable that a boiling point of the entire solvent is 100°C or higher.

In a case where the solvent is contained, the content of the specific compound according to the composition for forming the organic semiconductor film of the invention is preferably 0.05 to 50 mass%, more preferably 0.1 to 25 mass%, even more preferably 0.25 to 15 mass%, particularly preferably 0.4 to 10 mass%. The content of the binder polymer is preferably 0.01 to 50 mass%, more preferably 0.05 to 25 mass%, and even more preferably 0.1 to 10 mass%. If the content is in the range above, the coating properties are excellent, and the organic semiconductor film can be easily formed.

The drying treatment in the removing step is a treatment performed if necessary, and the optimal treatment conditions are appropriately selected according to the type of the specific compound used and the solvent. In view of further improving mobility and heat stability of the obtained organic semiconductor and improving productivity, a heating temperature is preferably 30°C to 100°C and more preferably 40°C to 80°C, and a heating time is preferably 10 to 300

minutes and more preferably 30 to 180 minutes.

A film thickness of the formed organic semiconductor layer is not particularly limited. From the viewpoint of mobility and heat stability of the obtained organic semiconductor, the film thickness is preferably 10 to 500 nm and more preferably 30 to 200 nm.

The organic semiconductor element is not particularly limited, but is preferably an organic semiconductor element having 2 to 5 terminals, and more preferably an organic semiconductor element having 2 or 3 terminals.

It is preferable that the organic semiconductor element is not a photoelectric conversion element.

The organic semiconductor element according to the invention is preferably a non-luminous organic semiconductor element.

Examples of a 2-terminal element include a rectifier diode, a constant voltage diode, a PIN diode, a Schottky barrier diode, a surge protection diode, a diac, a varistor, a tunnel diode, and the like.

Examples of a 3-terminal element include a bipolar transistor, a Darlington transistor, a field effect transistor, insulated gate bipolar transistor, a uni-junction transistor, a static induction transistor, a gate turn-off thyristor, a triac, a static induction thyristor, and the like.

Among these, a rectifier diode and transistors are preferable, and a field effect transistor is more preferable.

As the field effect transistor, an organic thin film transistor is preferable.

An aspect of the organic thin film transistor of the present invention will be described with reference to a drawing.

Fig. 1 is a schematic cross-sectional view of an aspect of an organic semiconductor element (organic thin film transistor (organic TFT)) of the present invention.

In Fig. 1, an organic thin film transistor 100 comprises a substrate 10, a gate electrode 20 disposed on the substrate 10, a gate insulating film 30 covering the gate electrode 20, a source electrode 40 and a drain electrode 42 which contact a surface of the gate insulating film 30 that is on the side opposite to the gate electrode 20 side, an organic semiconductor film 50 covering a surface of the gate insulating film 30 between the source electrode 40 and the drain electrode 42, and a sealing layer 60 covering each member. The organic thin film transistor 100 is a bottom gate-bottom contact type organic thin film transistor.

In Fig. 1, the organic semiconductor film 50 corresponds to a film formed of the composition described above.

Hereinafter, the substrate, the gate electrode, the gate insulating film, the source electrode, the drain electrode, the sealing layer, and methods for forming each of these will be specifically described.

<Substrate>

The substrate plays a role of supporting the gate electrode, the source electrode, the drain electrode, and the like which will be described later.

The type of the substrate is not particularly limited, and examples thereof include a plastic substrate, a glass substrate, a ceramic substrate, and the like. Among these, from the viewpoint of applicability to each device and costs, a glass substrate or a plastic substrate is preferable.

Examples of materials of the plastic substrate include a thermosetting resin (for example, an epoxy resin, a phenol resin, a polyimide resin, or a polyester resin (for example, polyethylene terephthalate (PET) or polyethylene naphthalate (PEN)) and a thermoplastic resin (for example, a phenoxy resin, a polyethersulfone, polysulfone, or polyphenylene sulfone).

Examples of materials of the ceramic substrate include alumina, aluminum nitride, zirconia, silicon, silicon nitride, silicon carbide, and the like.

Examples of materials of the glass substrate include soda lime glass, potash glass, borosilicate glass, quartz glass, aluminosilicate glass, lead glass, and the like.

<Gate electrode, source electrode, and drain electrode>

Examples of materials of the gate electrode, the source electrode, and the drain electrode include a metal such as gold (Au), silver, aluminum (Al), copper, chromium, nickel, cobalt, titanium, platinum, tantalum, magnesium, calcium, barium, or sodium; a conductive oxide such as $InO_2$, $SnO_2$, or indium tin oxide (ITO); a conductive polymer such as polyaniline, polypyrrole, polythiophene, polyacetylene, or polydiacetylene; a semiconductor such as silicon, germanium, or gallium arsenide; a carbon material such as fullerene, carbon nanotubes, or graphite; and the like. Among these, a metal is preferable, and silver and aluminum are more preferable.

A thickness of each of the gate electrode, the source electrode, and the drain electrode is not particularly limited, but is preferably 20 to 200 nm.

A method of forming the gate electrode, the source electrode, and the drain electrode is not particularly limited, but examples thereof include a method of vacuum vapor-depositing or sputtering an electrode material onto a substrate, a method of coating a substrate with a composition for forming an electrode, a method of printing a composition for

forming an electrode onto a substrate, and the like. Furthermore, in a case where the electrode is patterned, examples of the patterning method include a photolithography method; a printing method such as ink jet printing, screen printing, offset printing, or relief printing; a mask vapor deposition method; and the like.

<Gate insulating film>

Examples of materials of the gate insulating film include a polymer such as polymethyl methacrylate, polystyrene, polyvinylphenol, polyimide, polycarbonate, polyester, polyvinylalcohol, polyvinyl acetate, polyurethane, polysulfone, polybenzoxazole, polysilsesquioxane, an epoxy resin, or a phenol resin; an oxide such as silicon dioxide, aluminum oxide, or titanium oxide; a nitride such as silicon nitride; and the like. Among these materials, in view of the compatibility with the organic semiconductor film, a polymer is preferable.
In a case where a polymer is used as the material of the gate insulating film, it is preferable to use a cross-linking agent (for example, melamine) in combination. If the cross-linking agent is used in combination, the polymer is cross-linked, and durability of the formed gate insulating film is improved.
A film thickness of the gate insulating film is not particularly limited, but is preferably 100 to 1,000 nm.
A method of forming the gate insulating film is not particularly limited, but examples thereof include a method of coating a substrate, on which the gate electrode is formed, with a composition for forming a gate insulating film, a method of vapor-depositing or sputtering the material of the gate insulating film onto a substrate on which the gate electrode is formed, and the like. A method of coating the aforementioned substrate with the composition for forming a gate insulating film is not particularly limited, and it is possible to use a known method (a bar coating method, a spin coating method, a knife coating method, or a doctor blade method).
In a case where the gate insulating film is formed by coating the substrate with the composition for forming a gate insulating film, for the purpose of removing the solvent, causing cross-linking, or the like, the composition may be heated (baked) after coating.

<Binder polymer layer>

The organic semiconductor element of the present invention preferably has a layer of the aforementioned binder polymer between a layer containing the aforementioned organic semiconductor layer and an insulating film, and more preferably has a layer of the aforementioned binder polymer between the aforementioned organic semiconductor layer and the gate insulating film. A film thickness of the binder polymer layer is not particularly limited, but is preferably 20 to 500 nm. The binder polymer layer should be a layer containing the aforementioned polymer, and is preferably a layer composed of the aforementioned binder polymer.
A method of forming the binder polymer layer is not particularly limited, and a known method (a bar coating method, a spin coating method, a knife coating method, a doctor blade method, or an ink jet method) can be used.
In a case where the binder polymer layer is formed by performing coating by using a composition for forming a binder polymer layer, for the purpose of removing a solvent, causing cross-linking, or the like, the composition may be heated (baked) after coating.

<Sealing layer>

From the viewpoint of durability, the organic semiconductor element of the present invention preferably comprises a sealing layer as an outermost layer. In the sealing layer, a known sealant can be used.
A thickness of the sealing layer is not particularly limited, but is preferably 0.2 to 10 $\mu$m.
A method of forming the sealing layer is not particularly limited, but examples thereof include a method of coating a substrate, on which the gate electrode, the gate insulating film, the source electrode, the drain electrode, and the organic semiconductor film are formed, with a composition for forming a sealing layer, and the like. Specific examples of the method of coating the substrate with the composition for forming a sealing layer are the same as the examples of the method of coating the substrate with the composition for forming a gate insulating film. In a case where the organic semiconductor film is formed by coating the substrate with the composition for forming a sealing layer, for the purpose of removing the solvent, causing cross-linking, or the like, the composition may be heated (baked) after coating.
Fig. 2 is a schematic cross-sectional view of another aspect of the organic semiconductor element (organic thin film transistor) of the present invention.
In Fig. 2, an organic thin film transistor 200 comprises the substrate 10, the gate electrode 20 disposed on the substrate 10, the gate insulating film 30 covering the gate electrode 20, the organic semiconductor film 50 disposed on the gate insulating film 30, the source electrode 40 and the drain electrode 42 disposed on the organic semiconductor film 50, and the sealing layer 60 covering each member. Herein, the source electrode 40 and the drain electrode 42 are formed using the aforementioned composition of the present invention. The organic thin film transistor 200 is a bottom

gate-top contact type organic thin film transistor.

The substrate, the gate electrode, the gate insulating film, the source electrode, the drain electrode, the organic semiconductor film, and the sealing layer are as described above.

In Figs. 1 and 2, the aspects of the bottom gate-bottom contact type organic thin film transistor and the bottom gate-top contact type organic thin film transistor were specifically described. However, the organic semiconductor element of the present invention can also suitably used in a top gate-bottom contact type organic thin film transistor and a top gate-top contact type organic thin film transistor.

The organic thin film transistor described above can be suitably used for electronic paper and a display device.

(Composition for forming organic semiconductor film)

The composition for forming the organic semiconductor film according to the invention contains a specific compound and a solvent.

The composition for forming the organic semiconductor film according to the invention preferably contains a binder polymer.

The specific compound, the binder polymer, and the solvent in the composition for forming the organic semiconductor film according to the invention have the same meanings as the specific compound, the binder polymer, and the solvent described above, and preferable aspects thereof are also the same.

The composition for forming the organic semiconductor film according to the invention may include other component in addition to the specific compound and the binder polymer.

As the component, well-known additives may be used.

The content of the component in addition to the specific compound and the binder polymer in the composition for forming the organic semiconductor film according to the invention is preferably 10 mass% or less, more preferably 5 mass% or less, even more preferably 1 mass% or less, and particularly preferably 0.1 mass% or less with respect to the total solid content. If the content is in the range described above, film formability is improved, and mobility and heat stability of the obtained organic semiconductor are further improved. The solid content is an amount of the components excluding the volatilizable component such as the solvent.

The viscosity of the composition for forming the organic semiconductor film according to the invention is not particularly limited. However, in view of excellent coating properties, the viscosity is preferably 3 to 100 mPa·s, more preferably 5 to 50 mPa·s, and even more preferably 9 to 40 mPa·s. The viscosity according to the invention refers to viscosity at 25°C.

As a method of measuring the viscosity, a measuring method in conformity of JIS Z8803 is preferable.

The method of manufacturing the composition for forming the organic semiconductor film according to the invention is not particularly limited, and well-known methods can be applied. For example, a desired composition can be obtained by adding a specific amount of a specific compound in the solvent and applying an appropriate stirring treatment. In a case where the binder polymer is used, the specific compound and the binder polymer are simultaneously or sequentially added, so as to suitably manufacture the composition.

(Organic semiconductor film)

The organic semiconductor film according to the invention contains the specific compound.

The organic semiconductor film according to the invention preferably contains a binder polymer.

The specific compound and the binder polymer in the organic semiconductor film according to the invention have the same meanings as the specific compound and the binder polymer described above in the organic semiconductor element according to the invention, and preferable aspects thereof are also the same.

The composition for forming the organic semiconductor film according to the invention may include other components in addition to the specific compound and the binder polymer.

As the component, well-known additives may be used.

The content of the component in addition to the specific compound and the binder polymer in the organic semiconductor film according to the invention preferably 10 mass% or less, more preferably 5 mass% or less, even more preferably 1 mass% or less, and particularly preferably 0.1 mass% or less. If the content is in the range above, film formability is improved, and mobility and heat stability of the obtained organic semiconductor are further improved. The solid content is an amount of components other than the volatilizable components such as the solvent.

The film thickness of the organic semiconductor film according to the invention is not particularly limited. However, in view of mobility and heat stability of the obtained organic semiconductor, the film thickness is preferably 10 to 500 nm and more preferably 30 to 200 nm.

The organic semiconductor film according to the invention can be suitably used in the organic semiconductor element, and can be particularly suitably used in the organic transistor (organic thin film transistor).

The organic semiconductor film according to the invention can be suitably manufactured by using the composition for forming the organic semiconductor film according to the invention.

Examples

Hereinafter, the present invention will be more specifically described based on examples. The materials and the amount thereof used, the proportion of the materials, the content and procedure of treatments, and the like described in the following examples can be appropriately changed within a scope that does not depart from the gist of the present invention. Accordingly, the scope of the present invention is not limited to the following specific examples. Herein, unless otherwise specified, "part" and "%" are based on mass.

(Organic semiconductor compound)

Structures of Compounds 1 to 10 and Comparative Compounds 1 to 5 which were organic semiconductor compounds used in the organic semiconductor layer were provided below.

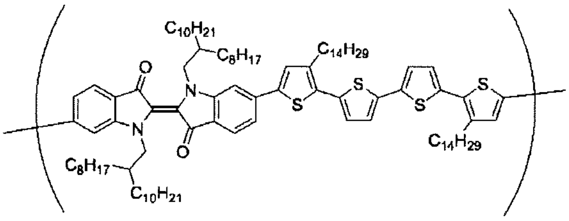

Compound 1

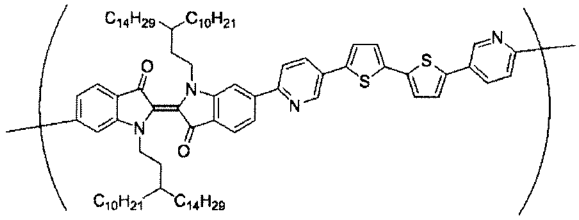

Compound 2

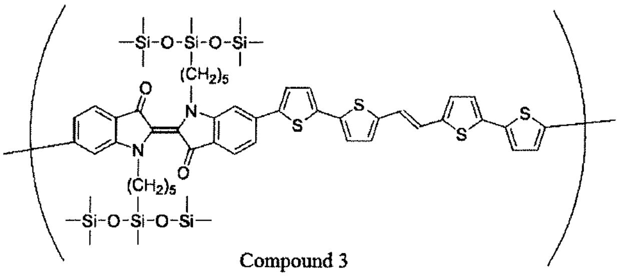

Compound 3

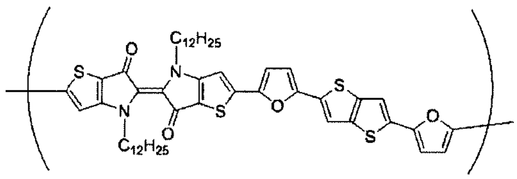

Compound 4

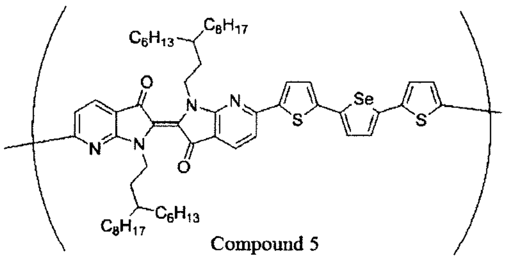

Compound 5

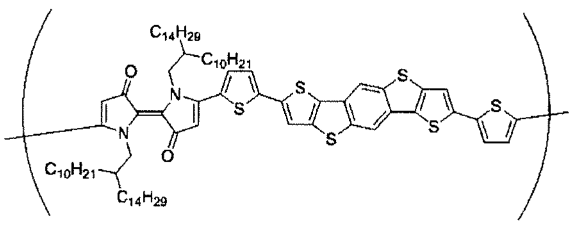

Compound 6

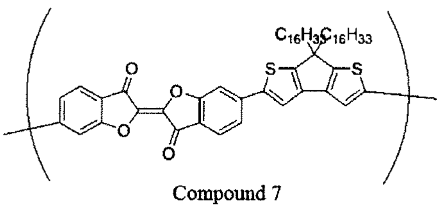

Compound 7

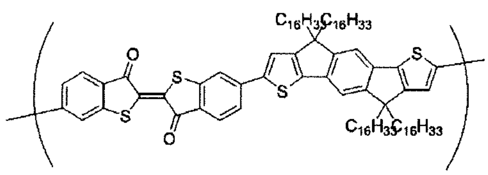

Compound 8

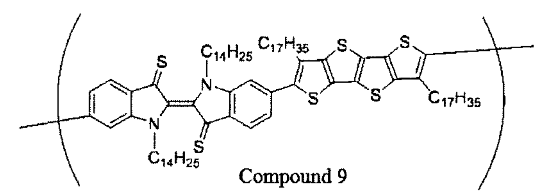

Compound 9

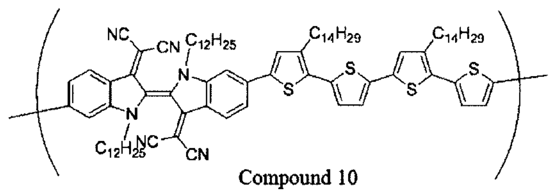

Compound 10

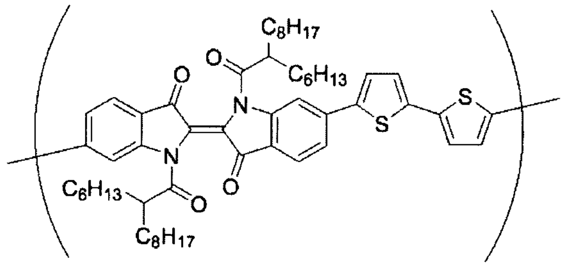

Comparative Compound 1

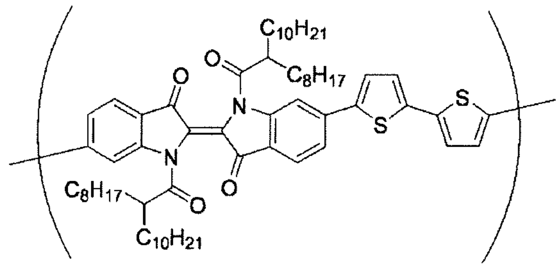

Comparative Compound 2

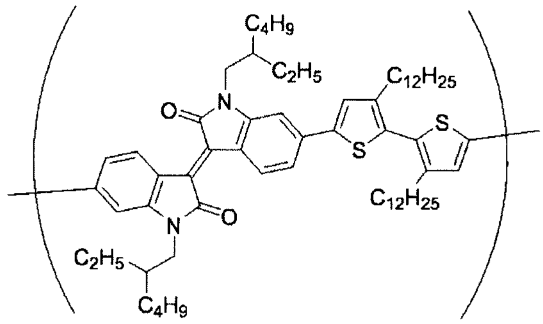

Comparative Compound 3

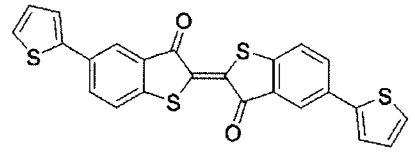

Comparative Compound 4

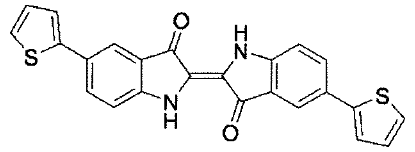

Comparative Compound 5

Compound 1 was synthesized in a synthesis scheme below.

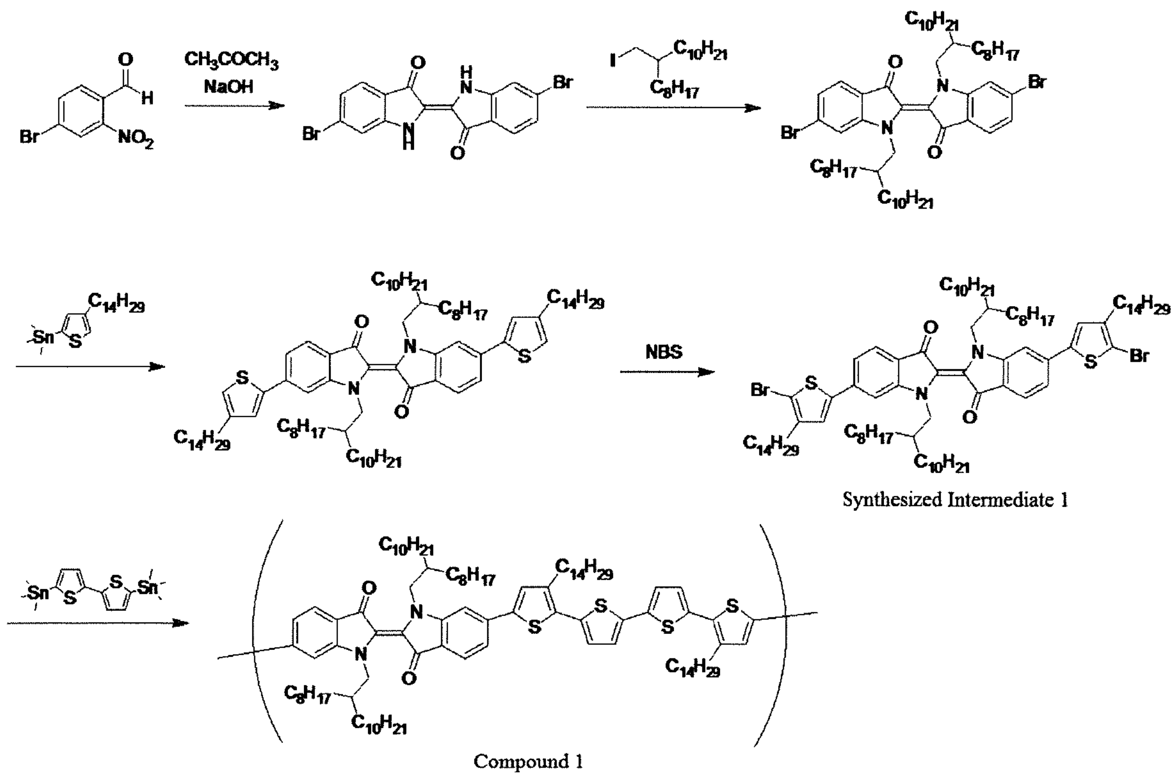


Synthesized Intermediate 1

Compound 1

With reference to J. Mater. Chem. C, 2014, 2, 4289., Liebigs Ann. Chem., 1980, 4, 564. and the like, Synthesized Intermediate 1 was synthesized in a route above.

Synthesized Intermediate 1 (617 mg, 0.401 mmol), 5,5'-bis(trimethylstannyl) bithiophene (manufactured by Sigma-Aldrich Co. LLC., 197 mg, 0.401 mmol), and tri(o-tolyl) phosphine (manufactured by manufactured by Wako Pure Chemical Industries, Ltd., 9.8 mg, 0.0321 mmol) were mixed, nitrogen was substituted in the system, dehydrated chlorobenzene (manufactured by Wako Pure Chemical Industries, Ltd., 8 mL) and tris(dibenzylideneacetone) dipalladium (manufactured by Tokyo Chemical Industry Co., Ltd., 7.3 mg, 0.008 mmol) were added, and stirring was performed at 90°C for 60 hours. After the reaction solution was cooled to room temperature, methanol was added, and stirring was performed for 30 minutes. The precipitated solid content was filtrated and washed with methanol, and then soxhlet extraction was performed sequentially with acetone, hexane and chloroform. The obtained polymer was heated to 130°C together with tetrachloroethane, cooling was performed to room temperature, an insoluble matter was filtered, and tetrachloroethane was distilled off under reduced pressure, so as to obtain 464 mg of Compound 1 (yield: 75%).

Examples of the terminal group of Compound 1 include a combination in which a 2-bromo-3-tetradecanylthiophen-5-yl group which was a partial structure of Synthesized Intermediate 1 was bonded to the left side of the constitutional repeating unit and a group in which one of the 2-bromo-3-tetradecanylthiophen-5-yl group was removed from Synthesized Intermediate 1 was bonded to the right side of the constitutional repeating unit. Other examples of the terminal group include a group in which a bromine atom of the 2-bromo-3-tetradecanylthiophen-5-yl group was substituted with a 2'-(5'-(2"-thiophenyl)) thiophenyl group. Other examples of the terminal group include a group in which a bromine atom of a group in which one of the 2-bromo-3-tetradecanylthiophen-5-yl group was removed from Synthesized Intermediate 1 is substituted with a 2'-(5'-(2"-thiophenyl)) thiophenyl group.

That is, an occupied mass ratio of two terminal groups in the specific compound of which the weight-average molecular weight was 10,000 or greater was small, and thus importance thereof was low. Two terminal groups were changed depending on types of intermediate used in the synthesis and reactive organic tin compound and contents thereof. The terminal groups were changed depending on the reaction terminator used after the synthesis reaction. A functional group was introduced to a terminal group by a method well known to a skilled person in the art.

Compounds 2 to 10 were synthesized by a method in conformity with Compound 1.

Comparative Compounds 1 and 2 were P1 and P2 disclosed in J. Mater. Chem. C, 2014, 2, 4289. Comparative Compounds 3 and 4 were Exemplary Compounds (21) and (31) disclosed in JP2008-98454A. Comparative Compound 5 was P1 disclosed in examples of JP2011-501451A.

(Binder polymer)

A polymer (binder polymer) used as a binder is provided below.

PαMS: Poly-α-methylstyrene, weight-average molecular weight: 437,000, manufactured by Sigma-Aldrich Co. LLC.
PTAA: Poly[bis(4-phenyl)(2,4,6-trimethylphenyl)amine], number-average molecular weight: 7,000 to 10,000, manufactured by Sigma-Aldrich Co. LLC.
PCPDTBT: Poly[2,6-(4,4-bis(2-ethylhexyl)-4H cyclopenta[2,1-b;3,4-b']dithiophene)-alt-4,7-(2,1,3-benzothiadiazole)], weight-average molecular weight: 7,000 to 20,000, manufactured by Sigma-Aldrich Co. LLC.

(Preparing coating liquid for forming organic semiconductor film)

An organic semiconductor compound (0.25 wt%)/a binder polymer (concentration disclosed in Table 1)/anisole presented in Table 1 was weighed in glass vial, stirring and mixing was performed for 10 minutes with a mix rotor (manufactured by As One Corporation), and filtration was performed with a 0.5 μm membrane filter, so as to obtain a coating liquid (the composition for forming the organic semiconductor film) for forming the organic semiconductor film. In Table 1, "-" presented in a polymer (binder polymer) indicates that the polymer (binder polymer) was not included.

(Manufacturing of TFT element)

A1 that became a gate electrode was vapor-deposited on the glass substrate (EAGLE XG: manufactured by Corning Incorporated) (Thickness: 50 nm). Spin coating was performed with a composition (solution (concentration of solid contents: 2 mass%) of propylene glycol monomethyl ether acetate (PGMEA) of polyvinylphenol/melamine=1 part by mass/1 part by mass (w/w)) for forming a gate insulating film, and the gate insulating film having a film thickness of 400 nm was formed by performing baking at 150°C for 60 minutes. Shapes of source electrodes and drain electrodes (channel length: 40 μm, channel width: 200 μm) were drawn thereon, with silver ink (H-1, manufactured by Mitsubishi Materials Corporation) by using an inkjet device DMP-2831 (manufactured by Fujifilm Corporation). Thereafter, baking was performed in an oven at 180°C for 30 minutes, sintering was performed, and source electrodes and drain electrodes were formed, so as to obtain an element substrate for TFT characteristic evaluation.

In a nitrogen glove box, spin coating was performed on the element substrate for TFT characteristic evaluation with coating liquid (the composition for forming the organic semiconductor film) for forming the respective organic semiconductor films (for 10 seconds at 500 rpm and for 30 seconds at 1,000 rpm), and drying was performed on a hot plate at 120°C for 10 minutes, so as to form an organic semiconductor layer such that a bottom gate bottom contact-type organic TFT element was obtained.

(Characteristic evaluation)

The following performance evaluation was carried out under the atmosphere by using a semiconductor characteristic evaluation device B2900A (manufactured by Agilent Technologies).

(a) Carrier mobility and (b) Variation of Mobility

Carrier mobility μ was calculated by applying a voltage of -60V between source electrodes-drain electrodes of the respective organic TFT elements, changing gate voltages in the range of +10 V to -60 V, and using an equation below indicating a drain current $I_d$.

$$I_d=(w/2L)\mu C_i(V_g-V_{th})^2$$

In the equation, L represents a gate length, w represents a gate width, $C_i$ represents capacity per unit area of an insulating layer, Vg represents a gate voltage, and $V_{th}$ represents a threshold voltage.

The value of the carrier mobility presented in Table 1 is an average value of 10 elements. As carrier mobility μ is higher, the carrier mobility μ is more preferable. In practice the carrier mobility μ is preferably $1\times10^{-2}$ cm²/Vs or greater and more preferably $1\times10^{-1}$ $cm^2$/Vs or greater. If the mobility was lower than $1\times10^{-5}$ $cm^2$/Vs, characteristics were too small, and thus the evaluation was not performed.

With respect to the carrier mobility of 10 elements, a coefficient of variation calculated in an equation below was evaluated in five stages below and was used as an index of variation of mobility. As this value is smaller, the value

indicates that the variation of mobility between elements was smaller. In practice, A or B is preferable and A is more preferable.

$$\text{Coefficient of variation}=\text{Standard deviation}/\text{average value}\times 100$$

<Evaluation standard>

A: Less than 15%
B: 15% or greater and less than 30%
C: 30% or greater and less than 50%
D: 50% or greater

(c) Heat resistance

After the manufactured respective organic thin film transistor element was heated in a nitrogen glove box at 150°C for one hour, carrier mobility was measured in the same manner as in (a), a carrier mobility maintenance ratio after heating calculated from the equation below was evaluated in four stages below, and the carrier mobility maintenance ratio was set as an index of the heat resistance. As this value was greater, heat resistance was higher. In practice, A was preferable.

$$\text{Carrier mobility maintenance ratio after heating (\%)}=\text{mobility (after heating)}/\text{mobility (before heating)}$$

<Evaluation standard>

A: 80% or greater
B: 60% or greater and less than 80%
C: 40% or greater and less than 60%
D: Less than 40%

[Table 1]

| Element Number | Organic semiconductor (Specific compound) | Mn | Mw | Binder Polymer (wt%) | Carrier Mobility ($cm^2/Vs$) | Variation of Mobility | Heat resistance |
|---|---|---|---|---|---|---|---|
| Element 1-1 | Compound 1 | 30,000 | 120,000 | - | $4.9\times10^{-2}$ | A | A |
| Element 1-2 | Compound 1 | 30,000 | 120,000 | P$\alpha$MS(0.50) | $5.9\times10^{-2}$ | A | A |
| Element 1-3 | Compound 2 | 22,000 | 84,000 | - | $1.7\times10^{-2}$ | A | A |
| Element 1-4 | Compound 3 | 17,000 | 54,000 | - | $2.0\times10^{-2}$ | A | A |
| Element 1-5 | Compound 3 | 17,000 | 54,000 | PTAA (0.125) | $2.2\times10^{-2}$ | A | A |

(continued)

| Element Number | Organic semiconductor (Specific compound) | Mn | Mw | Binder Polymer (wt%) | Carrier Mobility ($cm^2/Vs$) | Variation of Mobility | Heat resistance |
|---|---|---|---|---|---|---|---|
| Element 1-6 | Compound 4 | 31,000 | 130,000 | - | $2.9\times10^{-2}$ | A | A |
| Element 1-7 | Compound 5 | 24,000 | 90,000 | - | $1.6\times10^{-2}$ | A | A |
| Element 1-8 | Compound 6 | 28,000 | 130,000 | - | $1.1\times10^{-2}$ | A | A |
| Element 1-9 | Compound 7 | 26,000 | 96,000 | - | $3.2\times10^{-2}$ | A | B |
| Element 1-10 | Compound 8 | 81,000 | 330,000 | - | $5.7\times10^{-2}$ | A | A |
| Element 1-11 | Compound 8 | 81,000 | 330,000 | PCPDTBT(0.25) | $5.9\times10^{-2}$ | A | A |
| Element 1-12 | Compound 9 | 37,000 | 160,000 | - | $5.3\times10^{-2}$ | A | B |
| Element 1-13 | Compound 10 | 34,000 | 140,000 | - | $2.1\times10^{-2}$ | A | B |
| Element 1-14 | Comparative Compound 1 | 14,000 | 47,000 | - | $<1\times10^{-5}$ | - | - |
| Element 1-15 | Comparative Compound 2 | 12,000 | 130,000 | - | $<1\times10^{-5}$ | - | - |
| Element 1-16 | Comparative Compound 3 | 22,000 | 140,000 | - | $6.3\times10^{-4}$ | D | D |
| Element 1-17 | Comparative Compound 4 | - | - | - | $3.4\times10^{-5}$ | D | D |
| Element 1-18 | Comparative Compound 5 | - | - | - | $<1\times10^{-5}$ | - | - |

Explanation of References

10: substrate
20: gate electrode
30: gate insulating film
40: source electrode
42: drain electrode
50: organic semiconductor film
60: sealing layer
100,200: organic thin film transistor

## Claims

**1.** An organic semiconductor element, comprising:

an organic semiconductor layer containing a compound having a constitutional repeating unit represented by

Formula 1 or 2 below,

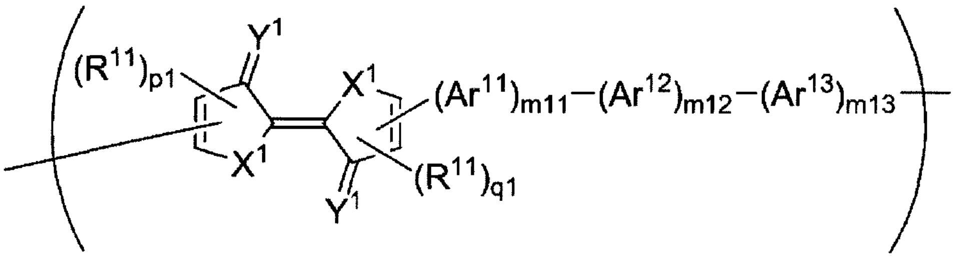

(1)

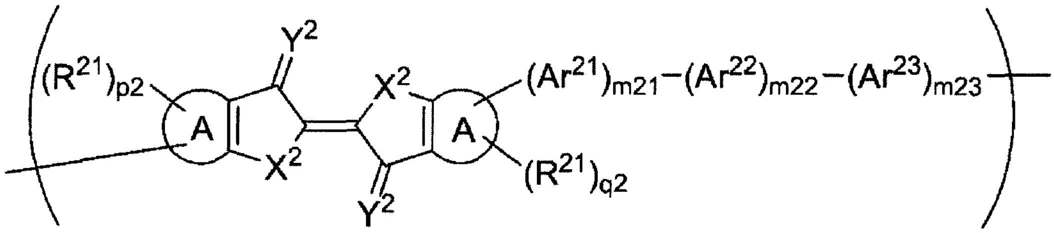

(2)

in Formulae 1 and 2, $X^1$ and $X^2$ each independently represent $CR^1_2$, O, S, Se, $NR^1$, or $SiR^1_2$, $R^1$'s each independently represent an alkyl group, an alkenyl group, an alkynyl group, an aromatic hydrocarbon group, or an aromatic heterocyclic group, $R^{11}$ and $R^{21}$ each independently represent a monovalent substituent, $Y^1$ and $Y^2$ each independently represent O, S, N-CN, or $CQ_2$, Q's each independently represent an alkyl group, CN, $C(=O)OR^2$, or $SO_2R^2$, $R^2$ represents a monovalent substituent, rings A each independently represent an aromatic hydrocarbon ring or an aromatic hetero ring, $Ar^{11}$, $Ar^{12}$, $Ar^{13}$, $Ar^{21}$, $Ar^{22}$, and $Ar^{23}$ each independently represent an aromatic hydrocarbon group, an aromatic heterocyclic group, a vinylene group, or an ethynylene group, m11 and m21 each represent an integer of 0 to 2, m12 and m22 each represent an integer of 0 to 4, m13 and m23 each represent an integer of 0 to 2, p1 and q1 each represent 0 or 1, p2 and q2 each represent an integer of 0 to 3.

**2.** The organic semiconductor element according to claim 1,
wherein the constitutional repeating unit represented by Formula 1 or 2 is represented by Formula 2, and
wherein the rings A each independently represent a group selected from the group consisting of a benzene ring, a pyridine ring, a pyrimidine ring, a pyrazine ring, a furan ring, a thiophene ring, a selenophene ring, and a pyrrole ring.

**3.** The organic semiconductor element according to claim 1 or 2,
wherein $X^1$ and $X^2$ each independently represent O, S, or $NR^1$.

**4.** The organic semiconductor element according to any one of claims 1 to 3,
wherein the constitutional repeating unit represented by Formula 1 or 2 is a constitutional repeating unit represented by Formula 3 below,

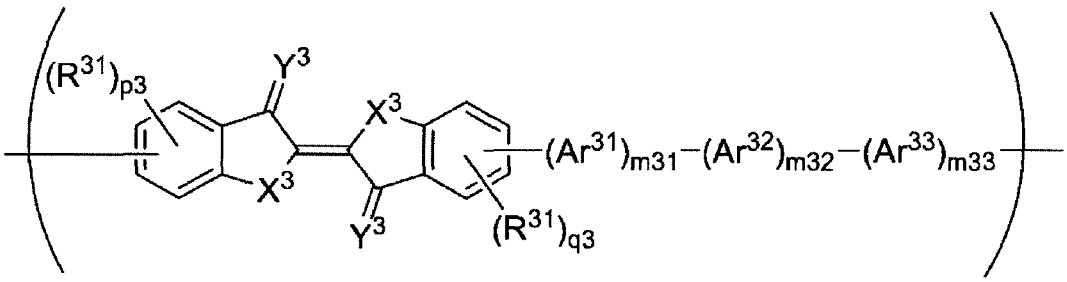

(3)

in Formula 3, $X^3$'s each independently represent $CR^1_2$, O, S, Se, $NR^1$, or $SiR^1_2$, $R^1$'s each independently represent an alkyl group, an alkenyl group, an alkynyl group, an aromatic hydrocarbon group, or an aromatic heterocyclic group, $R^{31}$'s each independently represent a monovalent substituent, $Y^3$'s each independently represent O, S, N-CN, or $CQ_2$, Q's each independently represent an alkyl group, CN, $C(=O)OR^2$, or $SO_2R^2$, $R^2$ represents a monovalent substituent, $Ar^{31}$, $Ar^{32}$, and $Ar^{33}$ each independently represent an aromatic hydrocarbon group, an aromatic heterocyclic group, a vinylene group, or an ethynylene group, m31 represents an integer of 0 to 2, m32 represents an integer of 0 to 4, m33 represents an integer of 0 to 2, and p3 and q3 each represent an integer of 0 to 3.

**5.** The organic semiconductor element according to claim 4,
wherein the constitutional repeating unit represented by Formula 3 is a constitutional repeating unit represented by Formula 4 below,

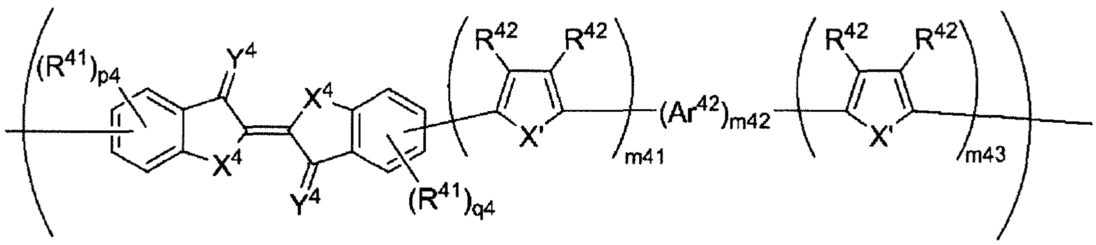
(4)

in Formula 4, $X^4$'s each independently represent $CR^1_2$, O, S, Se, $NR^1$, or $SiR^1_2$, $R^1$'s each independently represent an alkyl group, an alkenyl group, an alkynyl group, an aromatic hydrocarbon group, or an aromatic heterocyclic group, $R^{41}$'s each independently represent a monovalent substituent, $Y^4$'s each independently represent O, S, N-CN, or $CQ_2$, Q's each independently represent an alkyl group, CN, $C(=O)OR^2$, or $SO_2R^2$, $R^2$ represents a monovalent substituent, $Ar^{42}$'s each independently represent an aromatic hydrocarbon group, an aromatic heterocyclic group, a vinylene group, or an ethynylene group, m41 represents an integer of 0 to 2, m42 represents an integer of 0 to 4, m43 represents an integer of 0 to 2, p4 and q4 each represent an integer of 0 to 3, X''s each independently represent O or S, and $R^{42}$'s each independently represent a hydrogen atom or a monovalent substituent.

**6.** A compound comprising:

a constitutional repeating unit represented by Formula 1 or 2 below,

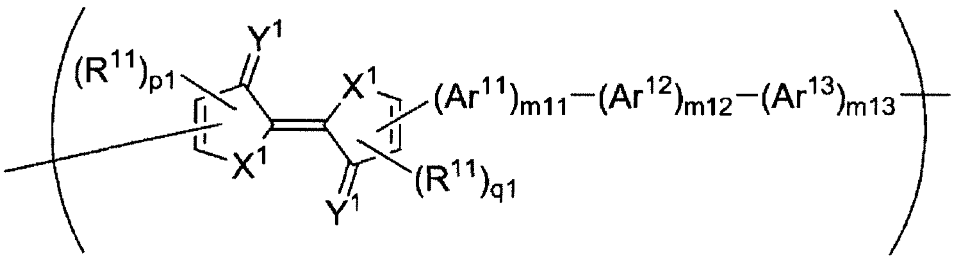
(1)

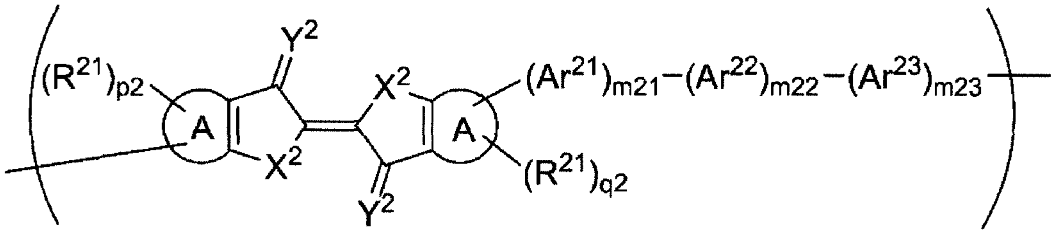
(2)

in Formulae 1 and 2, $X^1$ and $X^2$ each independently represent $CR^1_2$, O, S, Se, $NR^1$, or $SiR^1_2$, $R^1$'s each independently represent an alkyl group, an alkenyl group, an alkynyl group, an aromatic hydrocarbon group, or an aromatic heterocyclic group, $R^{11}$ and $R^{21}$ each independently represent a monovalent substituent, $Y^1$ and $Y^2$ each independently represent O, S, N-CN, or $CQ_2$, Q's each independently represent an alkyl group, CN, $C(=O)OR^2$ or $SO_2R^2$, $R^2$ represents a monovalent substituent, rings A each independently represent an aromatic hydrocarbon ring or an aromatic hetero ring, $Ar^{11}$, $Ar^{12}$, $Ar^{13}$, $Ar^{21}$, $Ar^{22}$, and $Ar^{23}$ each independently represent an aromatic hydrocarbon group, an aromatic heterocyclic group, a vinylene group, or an ethynylene group, m11 and m21 each represent an integer of 0 to 2, m12 and m22 each represent an integer of 0 to 4, m13 and m23 each represent an integer of 0 to 2, p1 and q1 each represent 0 or 1, and p2 and q2 each represent an integer of 0 to 3.

**7.** The compound according to claim 6,
wherein the constitutional repeating unit represented by Formula 1 or 2 is represented by Formula 2, and wherein the rings A are each independently selected from the group consisting of a benzene ring, a pyridine ring, a pyrimidine ring, a pyrazine ring, a furan ring, a thiophene ring, a selenophene ring, and a pyrrole ring.

**8.** The compound according to claim 6 or 7,
wherein $X^1$ and $X^2$ each independently represent O, S, or $NR^1$.

**9.** The compound according to any one of claims 6 to 8,
wherein the constitutional repeating unit represented by Formula 1 or 2 is a constitutional repeating unit represented by Formula 3 below,

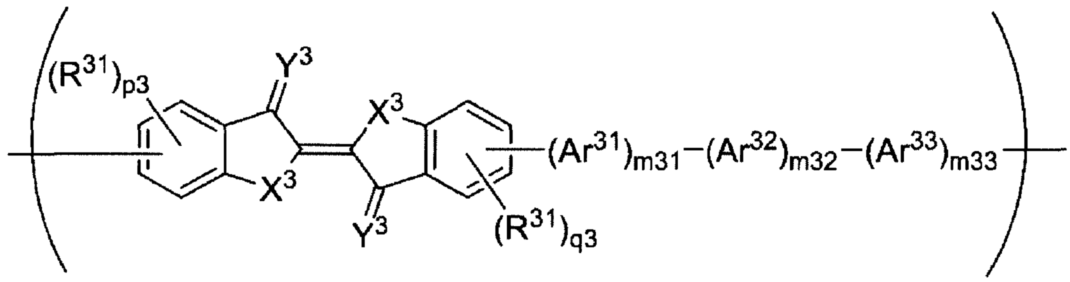 (3)

in Formula 3, $X^3$'s each independently represent $CR^1_2$, O, S, Se, $NR^1$, or $SiR^1_2$, $R^1$'s each independently represent an alkyl group, an alkenyl group, an alkynyl group, an aromatic hydrocarbon group, or an aromatic heterocyclic group, $R^{31}$'s each independently represent a monovalent substituent, $Y^3$'s each independently represent O, S, N-CN, or $CQ_2$, Q's each independently represent an alkyl group, CN, $C(=O)OR^2$, or $SO_2R^2$, $R^2$ represents a monovalent substituent, $Ar^{31}$, $Ar^{32}$, and $Ar^{33}$ each independently represent an aromatic hydrocarbon group, an aromatic heterocyclic group, a vinylene group, or an ethynylene group, m31 represents an integer of 0 to 2, m32 represents an integer of 0 to 4, m33 represents an integer of 0 to 2, and p3 and q3 each represent an integer of 0 to 3.

**10.** The compound according to claim 9,
wherein the constitutional repeating unit represented by Formula 3 is a constitutional repeating unit represented by Formula 4 below,

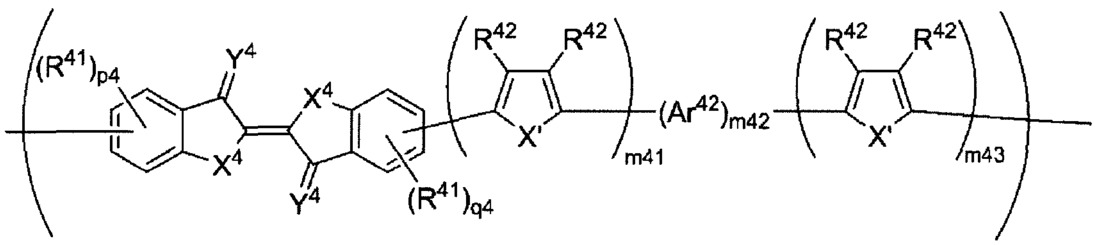 (4)

in Formula 4, $X^4$'s each independently represent $CR^1_2$, O, S, Se, $NR^1$, or $SiR^1_2$, $R^1$'s each independently represent an alkyl group, an alkenyl group, an alkynyl group, an aromatic hydrocarbon group, or an aromatic heterocyclic group, $R^{41}$'s each independently represent a monovalent substituent, $Y^4$'s each independently represent O, S, N-CN, or $CQ_2$, Q's each independently represent an alkyl group, CN, $C(=O)OR^2$, or $SO_2R^2$, $R^2$ represents a monovalent substituent, $Ar^{42}$'s each independently represent an aromatic hydrocarbon group, an aromatic heterocyclic group, a vinylene group, or an ethynylene group, m41 represents an integer of 0 to 2, m42 represents an integer of 0 to 4, m43 represents an integer of 0 to 2, p4 and q4 each represent an integer of 0 to 3, X''s each independently represent O or S, $R^{42}$'s each independently represent a hydrogen atom or a monovalent substituent.

**11.** The compound according to any one of claims 6 to 10, which is an organic semiconductor.

**12.** A composition for forming an organic semiconductor film, comprising:

a compound having a constitutional repeating unit represented by Formula 1 or 2 below; and
a solvent,

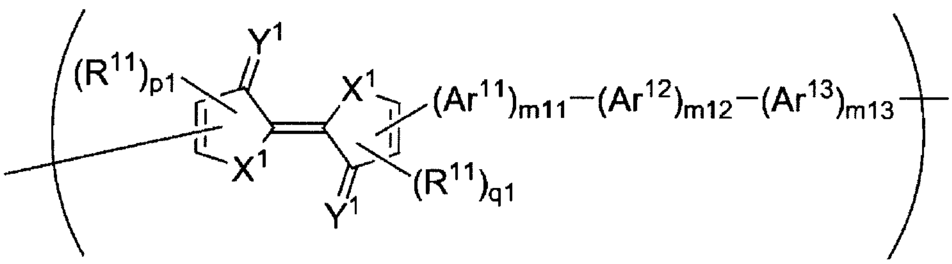

(1)

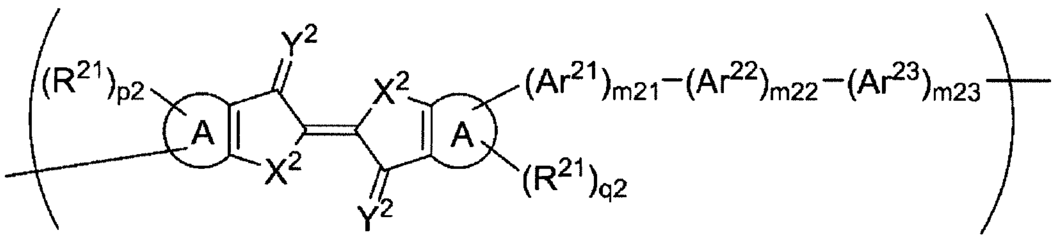

(2)

in Formulae 1 and 2, $X^1$ and $X^2$ each independently represent $CR^1_2$, O, S, Se, $NR^1$, or $SiR^1_2$, $R^1$'s each independently represent an alkyl group, an alkenyl group, an alkynyl group, an aromatic hydrocarbon group, or an aromatic heterocyclic group, $R^{11}$ and $R^{21}$ each independently represent a monovalent substituent, $Y^1$ and $Y^2$ each independently represent O, S, N-CN, or $CQ_2$, Q's each independently represent an alkyl group, CN, $C(=O)OR^2$, or $SO_2R^2$, $R^2$ represents a monovalent substituent, rings A each independently represent an aromatic hydrocarbon ring or an aromatic hetero ring, $Ar^{11}$, $Ar^{12}$, $Ar^{13}$, $Ar^{21}$, $Ar^{22}$, and $Ar^{23}$ each independently represent an aromatic hydrocarbon group, an aromatic heterocyclic group, a vinylene group, or an ethynylene group, m11 and m21 each represent an integer of 0 to 2, m12 and m22 each represent an integer of 0 to 4, m13 and m23 each represent an integer of 0 to 2, p1 and q1 each represent 0 or 1, and p2 and q2 each represent an integer of 0 to 3.

13. The composition for forming an organic semiconductor film according to claim 12, wherein a constitutional repeating unit represented by Formula 1 or 2 is represented by Formula 2, and the rings A are each independently selected from the group consisting of a benzene ring, a pyridine ring, a pyrimidine ring, a pyrazine ring, a furan ring, a thiophene ring, a selenophene ring, and a pyrrole ring.

14. The composition for forming an organic semiconductor film according to claim 12 or 13, wherein $X^1$ and $X^2$ each independently represent O, S, or $NR^1$.

15. The composition for forming an organic semiconductor film according to any one of claims 12 to 14, wherein a constitutional repeating unit represented by Formula 1 or 2 is a constitutional repeating unit represented by Formula 3 below,

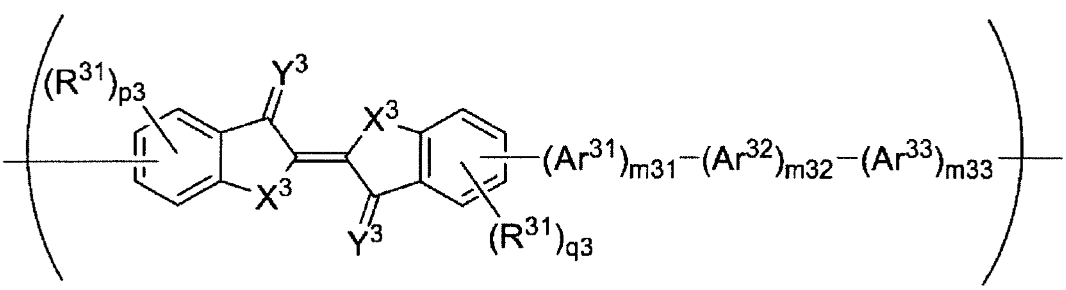

(3)

in Formula 3, $X^3$'s each independently represent $CR^1_2$, O, S, Se, $NR^1$, or $SiR^1_2$, $R^1$'s each independently represent an alkyl group, an alkenyl group, an alkynyl group, an aromatic hydrocarbon group, or an aromatic heterocyclic group, $R^{31}$'s each independently represent a monovalent substituent, $Y^3$'s each independently represent O, S, N-CN, or $CQ_2$, Q's each independently represent an alkyl group, CN, $C(=O)OR^2$, or $SO_2R^2$, $R^2$ represents a monovalent substituent, $Ar^{21}$, $Ar^{32}$, and $Ar^{33}$ each independently represent an aromatic hydrocarbon group, an aromatic heterocyclic group, a vinylene group, or an ethynylene group, m31 represents an integer of 0 to 2, m32 represents an

integer of 0 to 4, m33 represents an integer of 0 to 2, and p3 and q3 each represent an integer of 0 to 3.

**16.** The composition for forming an organic semiconductor film according to claim 15, wherein the constitutional repeating unit represented by Formula 3 is a constitutional repeating unit represented by Formula 4,

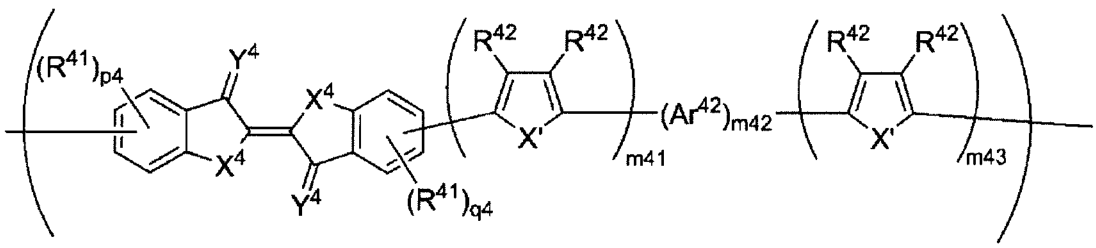

(4)

in Formula 4, $X^4$'s each independently represent $CR^1_2$, O, S, Se, $NR^1$, or $SiR^1_2$, $R^1$'s each independently represent an alkyl group, an alkenyl group, an alkynyl group, an aromatic hydrocarbon group, or an aromatic heterocyclic group, $R^{41}$'s each independently represent a monovalent substituent, $Y^4$'s each independently represent O, S, N-CN, or $CQ_2$, Q's each independently represent an alkyl group, CN, C(=O)$OR^2$, or $SO_2R^2$, $R^2$ represents a monovalent substituent, $Ar^{42}$'s each independently represent an aromatic hydrocarbon group, an aromatic heterocyclic group, a vinylene group, or an ethynylene group, m41 represents an integer of 0 to 2, m42 represents an integer of 0 to 4, m43 represents an integer of 0 to 2, p4 and q4 each represent an integer of 0 to 3, X"s each independently represent O or S, and $R^{42}$'s each independently represent a hydrogen atom or a monovalent substituent.

**17.** The composition for forming an organic semiconductor film according to any one of claims 12 to 16, wherein a concentration of the compound having the constitutional repeating unit represented by Formula 1 or 2 is 0.1 to 10 mass% with respect to the entire composition.

**18.** The composition for forming an organic semiconductor film according to any one of claims 12 to 17, wherein a boiling point of the solvent is 100°C or higher.

**19.** The composition for forming an organic semiconductor film according to any one of claims 12 to 18, further comprising:

a binder polymer.

**20.** A method of manufacturing an organic semiconductor element, comprising:

a coating step of coating a substrate with the composition for forming an organic semiconductor film according to any one of claims 12 to 19.

**21.** An organic semiconductor film comprising:

a compound having a constitutional repeating unit represented by Formula 1 or 2 below,

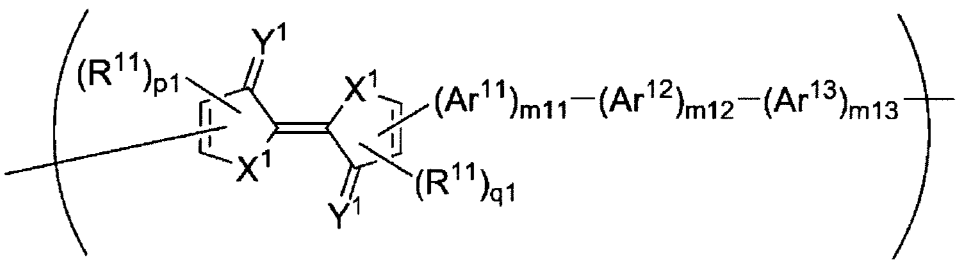

(1)

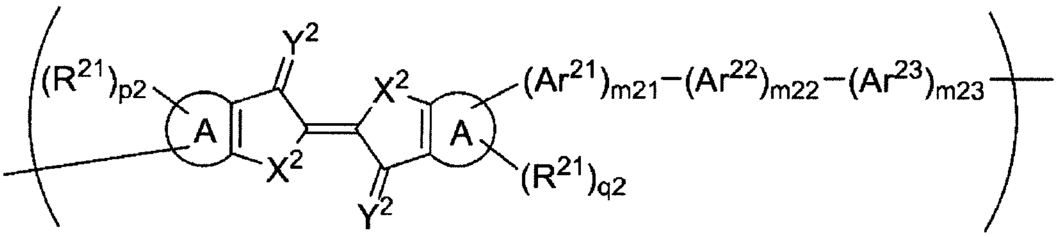

(2)

in Formulae 1 and 2, $X^1$ and $X^2$ each independently represent $CR^1_2$, O, S, Se, $NR^1$ or $SiR^1_2$, $R^1$'s each independently represent an alkyl group, an alkenyl group, an alkynyl group, an aromatic hydrocarbon group, or an aromatic heterocyclic group, $R^{11}$ and $R^{21}$ each independently represent a monovalent substituent, $Y^1$ and $Y^2$ each independently represent O, S, N-CN, or $CQ_2$, Q's each independently represent an alkyl group, CN, $C(=O)OR^2$, or $SO_2R^2$, $R^2$ represents a monovalent substituent, rings A each independently represent an aromatic hydrocarbon ring or an aromatic hetero ring, $Ar^{11}$, $Ar^{12}$, $Ar^{13}$, $Ar^{21}$, $Ar^{22}$, and $Ar^{23}$ each independently represent an aromatic hydrocarbon group, an aromatic heterocyclic group, a vinylene group, or an ethynylene group, m11 and m21 each represent an integer of 0 to 2, m12 and m22 each represent an integer of 0 to 4, m13 and m23 each represent an integer of 0 to 2, p1 and q1 each represent 0 or 1, and p2 and q2 each represent an integer of 0 to 3.

**22.** The organic semiconductor film according to claim 21,
wherein the constitutional repeating unit represented by Formula 1 or 2 is represented by Formula 2, and
wherein the rings A are each independently selected from the group consisting of a benzene ring, a pyridine ring, a pyrimidine ring, a pyrazine ring, a furan ring, a thiophene ring, a selenophene ring, and a pyrrole ring.

**23.** The organic semiconductor film according to claim 21 or 22,
wherein $X^1$ and $X^2$ each independently represent O, S, or $NR^1$.

**24.** The organic semiconductor film according to any one of claims 21 to 23,
wherein the constitutional repeating unit represented by Formula 1 or 2 is a constitutional repeating unit represented by Formula 3 below,

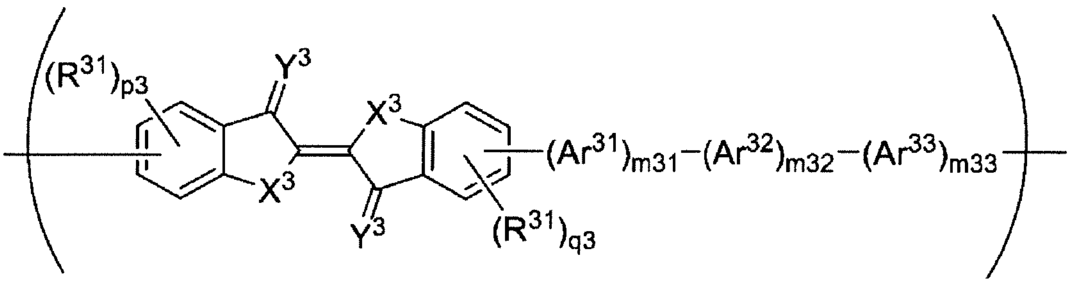

(3)

in Formula 3, $X^3$'s each independently represent $CR^1_2$, O, S, Se, $NR^1$, or $SiR^1_2$, $R^1$'s each independently represent an alkyl group, an alkenyl group, an alkynyl group, an aromatic hydrocarbon group, or an aromatic heterocyclic group, $R^{31}$'s each independently represent a monovalent substituent, $Y^3$'s each independently represent O, S, N-CN, or $CQ_2$, Q's each independently represent an alkyl group, CN, $C(=O)OR^2$, or $SO_2R^2$, $R^2$ represents a monovalent substituent, $Ar^{31}$, $Ar^{32}$, and $Ar^{33}$ each independently represent an aromatic hydrocarbon group, an aromatic heterocyclic group, a vinylene group, or an ethynylene group, m31 represents an integer of 0 to 2, m32 represents an integer of 0 to 4, m33 represents an integer of 0 to 2, and p3 and q3 each represent an integer of 0 to 3.

**25.** The organic semiconductor film according to claim 24,
wherein the constitutional repeating unit represented by Formula 3 is a constitutional repeating unit represented by Formula 4 below,

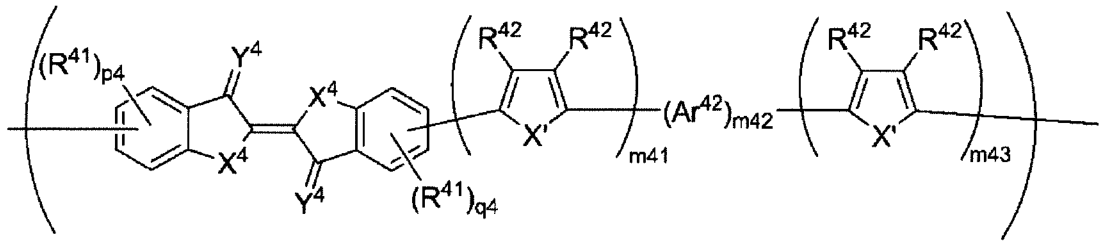

(4)

in Formula 4, $X^4$'s each independently represent $CR^1_2$, O, S, Se, $NR^1$, or $SiR^1_2$, $R^1$'s each independently represent an alkyl group, an alkenyl group, an alkynyl group, an aromatic hydrocarbon group, or an aromatic heterocyclic group, $R^{41}$'s each independently represent a monovalent substituent, $Y^4$'s each independently represent O, S, N-CN, or $CQ_2$, Q's each independently represent an alkyl group, CN, C(=O)$OR^2$, or $SO_2R^2$, $R^2$ represents a monovalent substituent, $Ar^{42}$'s each independently represent an aromatic hydrocarbon group, an aromatic heterocyclic group, a vinylene group, or an ethynylene group, m41 represents an integer of 0 to 2, m42 represents an integer of 0 to 4, m43 represents an integer of 0 to 2, p4 and q4 each represent an integer of 0 to 3, X"s each independently represent O or S, and $R^{42}$'s each independently represent a hydrogen atom or a monovalent substituent.

**26.** The organic semiconductor film according to any one of claims 21 to 25, which is formed by a solution coating method.

FIG. 1

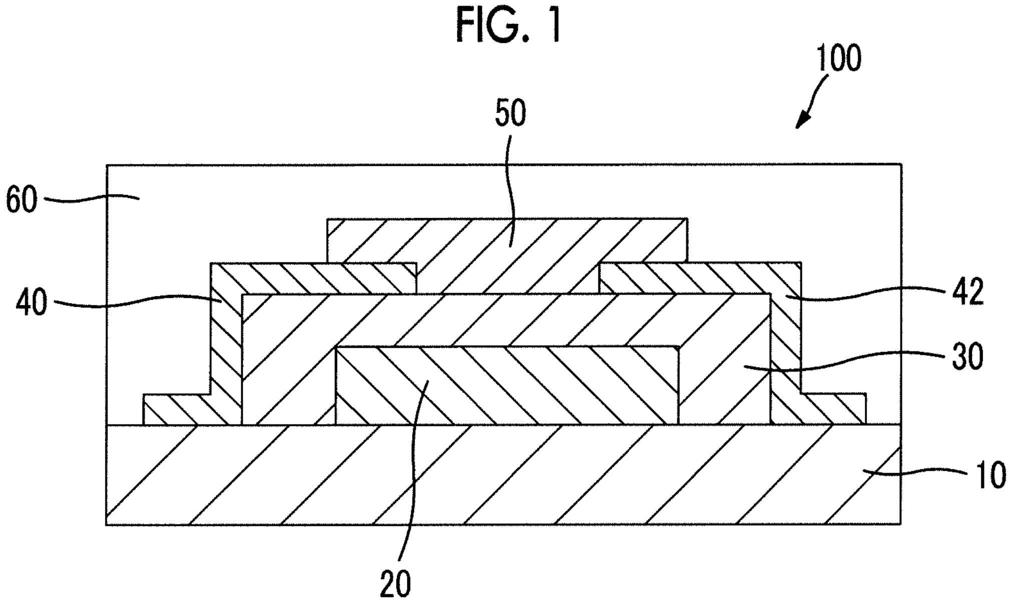


FIG. 2

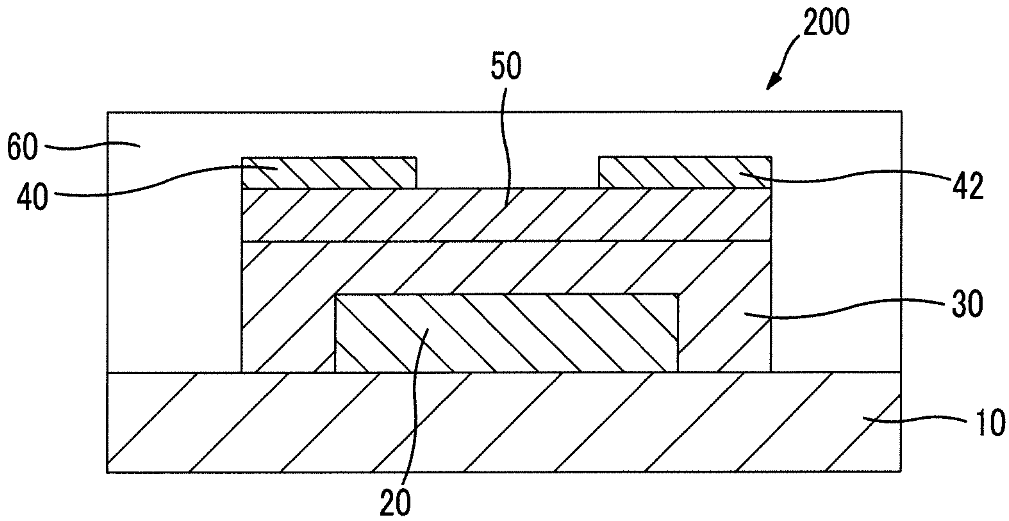

## INTERNATIONAL SEARCH REPORT

International application No. PCT/JP2015/081177

**A. CLASSIFICATION OF SUBJECT MATTER**

*H01L51/30*(2006.01)i, *C08G61/12*(2006.01)i, *C08L65/00*(2006.01)i, *C08L101/00*(2006.01)i, *H01L21/28*(2006.01)i, *H01L21/368*(2006.01)i, *H01L29/786*(2006.01)i, *H01L51/05*(2006.01)i

According to International Patent Classification (IPC) or to both national classification and IPC

**B. FIELDS SEARCHED**

Minimum documentation searched (classification system followed by classification symbols)
H01L51/30, C08G61/12, C08L65/00, C08L101/00, H01L21/28, H01L21/368, H01L29/786, H01L51/05

Documentation searched other than minimum documentation to the extent that such documents are included in the fields searched

| | | | |
|---|---|---|---|
| Jitsuyo Shinan Koho | 1922-1996 | Jitsuyo Shinan Toroku Koho | 1996-2016 |
| Kokai Jitsuyo Shinan Koho | 1971-2016 | Toroku Jitsuyo Shinan Koho | 1994-2016 |

Electronic data base consulted during the international search (name of data base and, where practicable, search terms used)
CAplus/REGISTRY(STN)

**C. DOCUMENTS CONSIDERED TO BE RELEVANT**

| Category* | Citation of document, with indication, where appropriate, of the relevant passages | Relevant to claim No. |
|---|---|---|
| X | GUO, Chang et al., Synthesis and properties of indigo based donor-acceptor conjugated polymers, Journal of Materials Chemistry C, 2014.03.04, vol. 2, pp. 4289-4296, particularly, Fig. 1 | 1-26 |
| A | JP 2013-118335 A (Sony Corp.), 13 June 2013 (13.06.2013), (Family: none) | 1-26 |
| A | JP 2008-98454 A (Toyo Ink Manufacturing Co., Ltd.), 24 April 2008 (24.04.2008), (Family: none) | 1-26 |

☐ Further documents are listed in the continuation of Box C. ☐ See patent family annex.

* Special categories of cited documents:
- "A" document defining the general state of the art which is not considered to be of particular relevance
- "E" earlier application or patent but published on or after the international filing date
- "L" document which may throw doubts on priority claim(s) or which is cited to establish the publication date of another citation or other special reason (as specified)
- "O" document referring to an oral disclosure, use, exhibition or other means
- "P" document published prior to the international filing date but later than the priority date claimed
- "T" later document published after the international filing date or priority date and not in conflict with the application but cited to understand the principle or theory underlying the invention
- "X" document of particular relevance; the claimed invention cannot be considered novel or cannot be considered to involve an inventive step when the document is taken alone
- "Y" document of particular relevance; the claimed invention cannot be considered to involve an inventive step when the document is combined with one or more other such documents, such combination being obvious to a person skilled in the art
- "&" document member of the same patent family

| Date of the actual completion of the international search | Date of mailing of the international search report |
|---|---|
| 27 January 2016 (27.01.16) | 09 February 2016 (09.02.16) |

| Name and mailing address of the ISA/ | Authorized officer |
|---|---|
| Japan Patent Office<br>3-4-3,Kasumigaseki,Chiyoda-ku,<br>Tokyo 100-8915,Japan | Telephone No. |

Form PCT/ISA/210 (second sheet) (January 2015)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP 2008098454 A
- JP 2011501451 A


### Non-patent literature cited in the description


- *J. Mater. Chem. C,* 2014, vol. 2, 4289
- *Liebigs Ann. Chem,* 1980, vol. 4, 564
- *Liebigs Ann. Chem.,* 1980, vol. 4, 564